(19) 
**Europäisches Patentamt**
**European Patent Office**
**Office européen des brevets**

(11) **EP 4 141 455 B1**

(12) **EUROPÄISCHE PATENTSCHRIFT**

(45) Veröffentlichungstag und Bekanntmachung des Hinweises auf die Patenterteilung:
**03.04.2024   Patentblatt 2024/14**

(21) Anmeldenummer: **21193583.8**

(22) Anmeldetag: **27.08.2021**

(51) Internationale Patentklassifikation (IPC):
***G01R 27/26*** *(2006.01)*

(52) Gemeinsame Patentklassifikation (CPC):
**G01R 27/2611**

(54) **GROSSSIGNALINDUKTIVITÄTSMESSEINRICHTUNG UND VERFAHREN ZUM DURCHFÜHREN EINES MESSVORGANGS ZUM MESSEN EINER INDUKTIVITÄT**

LARGE SIGNAL INDUCTANCE MEASURING DEVICE AND METHOD FOR PERFORMING A MEASURING PROCESS FOR MEASURING AN INDUCTANCE

DISPOSITIF DE MESURE DE L'INDUCTANCE DE SIGNAUX FORTS ET PROCÉDÉ DE MISE EN OEUVRE D'UN PROCESSUS DE MESURE D'UNE INDUCTANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**01.03.2023   Patentblatt 2023/09**

(73) Patentinhaber:
- **Fraunhofer-Gesellschaft zur Förderung der angewandten Forschung e.V.**
  **80686 München (DE)**
- **Friedrich-Alexander-Universität Erlangen-Nürnberg**
  **91054 Erlangen (DE)**

(72) Erfinder:
- **Gehring, Johannes**
  **91058 Erlangen (DE)**
- **Schwanninger, Raffael**
  **90427 Nürnberg (DE)**
- **Wunder, Bernd**
  **91058 Erlangen (DE)**

(74) Vertreter: **Zimmermann, Tankred Klaus et al**
**Schoppe, Zimmermann, Stöckeler Zinkler, Schenk & Partner mbB Patentanwälte**
**Radlkoferstrasse 2**
**81373 München (DE)**

(56) Entgegenhaltungen:
**WO-A1-2020/089462     US-A- 4 219 740**

**Beschreibung**

Für die Auslegung von Ausschaltern in DC-Anwendungen ist die geschaltete induktive Last von herausragender Bedeutung. Wird der Ausschalter in räumlich weit ausgedehnten Systemen, wie z.B. DC-Energieversorgungnetzen oder DC-Energieversorgungsleitungen, verwendet, spielt neben der tatsächlichen Last auch die Induktivität des Systems eine nicht zu vernachlässigende Rolle. Da diese Induktivitäten in der Regel einen nichtlinearen Anteil besitzen, ist eine einfache Kleinsignalmessung nicht ausreichend, um die tatsächliche Belastung für den Ausschalter zu bestimmen. Somit ist eine Großsignalinduktivitätsmesseinrichtung notwendig, welche die induktiv gespeicherte Energie bemisst, welche auf den Ausschalter wirkt.

Die Vermessung von Induktivitäten ist grundsätzlich bekannt und wird für eine Vielzahl von Anwendungen eingesetzt. Typischerweise werden diese Messungen jedoch für diskrete Induktivitäten, wie z.B. Drosseln, verwendet. Außerdem muss bei einer Impedanz-Messung immer zwischen einer Kleinsignalmessung und einer Großsignalmessung unterschieden werden. Kleinsignalmessungen, wie z.B. in [1] oder [2] beschrieben, prägen eine Störung mit geringer Amplitude auf das zu untersuchende Objekt auf und messen die Antwort des Systems auf diese Störung. Da Induktivitäten jedoch eine Nichtlinearität aufweisen können, kann von einer Kleinsignalstörung nicht generell auf das Verhalten bei einer Großsignalstörung geschlossen werden. Das vollständige Trennen des Stroms mittels des Ausschalters ist jedoch per Definition eine Großsignalstörung, weswegen Kleinsignalmessungen hier nicht verwendet werden können.

Messungen von Großsignalanregungen sind z.B. über die in [3] gezeigte Methode für gekoppelte Spulen möglich. Hierbei wird ein LC-Resonanzkreis angeregt und vermessen. Ähnlich ist die in [4] vorgestellte Lösung, bei der die Schwingung nicht durch einen Resonanzkreis, sondern durch aktives Schalten von Halbleitern erzeugt wird. In beiden Fällen kann die Resonanz jedoch nicht ohne weiteres in einem ausgedehnten DC-Netz angeregt werden, da die zur Anregung nötige Leistung sehr groß wäre. Außerdem wäre ein Betrieb des Netzes während der Messung nicht mehr möglich und die Funktionsweise anderer Teilnehmer am Netz mindestens stark eingeschränkt. In [5] wird die Messung von diskreten Induktivitäten über eine Referenzmessung beschrieben. Für diese Messung muss jedoch ein Strom sowohl auf den Prüfling als auch eine Referenzinduktivität parallel eingeprägt werden. Da ein DC-Netz eine hohe Ausdehnung hat und gegebenenfalls mehrere Einspeisepunkte haben kann, ist diese Lösung für die Anwendung in Netzen nicht praktikabel.

In AC-Netzen ist die Messung der Induktivität eines Netzes gut untersucht und verschiedene Methoden werden z.B. in [6] oder [7] beschrieben. In AC-Netzen ist die Netzinduktivität jedoch deutlich weniger relevant für Ausschalter, da der Laststrom während einer Periode zwei Nulldurchgänge hat, in denen ein im Ausschalter auftretender Lichtbogen erlöschen kann. Die Induktivität wird somit meist nur in Bezug auf die Stabilität des Netzes untersucht. Aufgrund des sinusförmigen Stromverlaufs sind die Messmethoden außerdem nicht für DC-Netze anwendbar.

In [8] wird eine Messung der Induktivität in einem DC-Netz vorgestellt. Diese Messung wird zusammen mit einer Widerstandsmessung durchgeführt, um zu überprüfen, ob das Einschalten auf eine ohmsch-induktive Last zu Problemen führen wird. Die Messung wird jedoch nur auf der Lastseite durchgeführt. Hierbei wird die Zeitantwort auf eine Anregung im Kleinsignalbereich vermessen. Wie zuvor beschrieben lässt eine Kleinsignalmessung jedoch nur bedingt Rückschlüsse auf das Verhalten im Großsignalbereich zu.

In [9] wird ein Verfahren zur Ermittlung der Induktivität eines elektrischen Bauelements beschrieben.

Die Aufgabe der vorliegenden Erfindung besteht darin, eine verbesserte Großsignalinduktivitätsmesseinrichtung zum Durchführen eines Messvorgangs zum Messen einer Induktivität an einer mit einer Gleichspannung betriebenen elektrischen Energieversorgungsleitungsanordnung zu verbessern.

Die Aufgabe wird gelöst durch eine Großsignalinduktivitätsmesseinrichtung zum Durchführen eines Messvorgangs zum Messen einer Induktivität an einer mit einer Gleichspannung betriebenen elektrischen Energieversorgungsleitungsanordnung mit einem ersten Leiter und mit einem zweiten Leiter, wobei die Großsignalinduktivitätsmesseinrichtung zum Anordnen zwischen einem ersten Abschnitt der Energieversorgungsleitungsanordnung, welcher mit einer elektrischen Energiequelle verbunden ist und einen quellseitigen Teil der Induktivität aufweist,

und einem zweiten Abschnitt der Energieversorgungsleitungsanordnung, welcher mit einer elektrischen Last verbunden ist und einen lastseitigen Teil der Induktivität aufweist, ausgebildet ist; wobei die Großsignalinduktivitätsmesseinrichtung umfasst:

einen Trennschalter zum elektrischen Trennen des ersten Leiters der Energieversorgungsleitungsanordnung;
eine erste Reihenschaltung umfassend eine erste kapazitive Anordnung und eine erste Diodenanordnung, wobei ein erstes Ende der ersten Reihenschaltung an einer quellseitigen Seite des Trennschalters mit dem ersten Leiter elektrisch verbunden ist, und welche derart ausgebildet ist, dass nach dem Trennen des ersten Leiters ein durch den quellseitigen Teil der Induktivität bewirkter erster Strom durch die erste Reihenschaltung fließt, der zu einer ersten Spannungsänderung an der ersten kapazitiven Anordnung führt;
eine erste Messeinrichtung zum Messen der ersten Spannungsänderung;
eine zweite Reihenschaltung umfassend eine zweite kapazitive Anordnung und eine zweite Diodenanordnung, wobei ein erstes Ende der zweiten Reihenschaltung an einer lastseitigen Seite des Trennschalters mit dem ersten Leiter elektrisch verbunden ist, und welche derart ausgebildet ist, dass nach dem Trennen des ersten Leiters ein durch den lastseitigen Teil der Induktivität bewirkter zweiter Strom durch die zweite Reihenschaltung fließt, der zu einer zweiten Spannungsänderung an der zweiten kapazitiven Anordnung führt;

eine zweite Messeinrichtung zum Messen der zweiten Spannungsänderung;

eine dritte Messeinrichtung zum Messen eines dritten Stroms auf dem ersten Leiter vor dem Trennen des ersten Leiters; und

eine Auswerteeinrichtung zum Auswerten der gemessenen ersten Spannungsänderung, der gemessenen zweiten Spannungsänderung und des gemessenen dritten Stroms, um aus der gemessenen ersten Spannungsänderung und aus dem gemessenen dritten Strom den quellseitigen Teil der Induktivität und um aus der gemessenen zweiten Spannungsänderung und aus dem gemessenen dritten Strom den lastseitigen Teil der Induktivität zu bestimmen.

Bei der elektrischen Energieversorgungsleitungsanordnung kann es sich um eine elektrische Energieversorgungsleitung oder um ein elektrisches Energieversorgungsnetz handeln. Bei dem ersten Leiter kann es sich um eine mit Isolierstoffen ummantelte Ader eines Kabels handeln. Ebenso kann es sich bei dem zweiten Leiter um eine weitere mit Isolierstoffen ummantelte Ader eines Kabels handeln. Denkbar ist aber auch, dass eine Masseverbindung oder eine Erdverbindung als zweiter Leiter verwendet wird.

Der Trennschalter ist dazu vorgesehen, den ersten Leiter an derjenigen Stelle elektrisch zu trennen, an der der auszulegende Ausschalter später eingebaut werden soll. Das Trennen des ersten Leiters mittels des Trennschalters kann durch die Auswerteeinrichtung gesteuert sein.

Bei den Diodenanordnungen kann es sich jeweils um eine einzelne Diode oder um eine Mehrzahl von Dioden handeln, welche parallel und/oder seriell geschaltet sind, um die Stromfestigkeit und/oder die Spannungsfestigkeit der jeweiligen Diodenanordnung zu erhöhen.

Bei den kapazitiven Anordnungen kann es sich jeweils um einen einzelnen Kondensator oder um eine Mehrzahl von Kondensatoren handeln, welche parallel und/oder seriell geschaltet sind, um die Stromfestigkeit und/oder die Spannungsfestigkeit der jeweiligen kapazitiven Anordnung zu erhöhen.

Die erste Messeinrichtung ist eine Spannungsmesseinrichtung, welche parallel zur ersten kapazitiven Anordnung geschaltet ist.

Die zweite Messeinrichtung ist eine Spannungsmesseinrichtung, welche parallel zur zweiten kapazitiven Anordnung geschaltet ist.

Die dritte Messeinrichtung ist eine Strommesseinrichtung, welche in Serie zum Trennschalter geschaltet ist.

Die Auswerteeinrichtung kann ein Prozessor sein, der in Hardware oder in einer Kombination von Hardware und Software ausgeführt ist.

Die vorgeschlagene Großsignalinduktivitätsmesseinrichtung erlaubt das Durchführen eines Messvorgangs zum Messen einer Induktivität an einer mit einer Gleichspannung betriebenen elektrischen Energieversorgungsleitungsanordnung mittels einer Großsignalmessung mit hoher Geschwindigkeit und mit hoher Genauigkeit. Durch die Separation des quellseitigen Teils der Induktivität und des lastseitigen Teils der Induktivität können auf beiden Seiten des Ausschalters (zur Energiequelle und zur Last) angepasste Lösungen zum Überlastschutz entworfen werden.

Die vorgeschlagene Großsignalinduktivitätsmesseinrichtung kann zur Auslegung von elektronischen, mechanischen oder hybriden Trennschaltern für industrielle DC-Netze, Elektrofahrzeugnetze, DC-Ladeinfrastruktur, oder PV-Anlagen sowie die Vermessung dieser Netze an verschiedenen Punkten eingesetzt werden. Außerdem kann sie zum Messen der Ausgangsinduktivität bei DC-Ladesäulen eingesetzt werden, was bei der normkonformen Prüfung von DC-Ladesäulen eine wichtige Rolle spielt.

Nach einer vorteilhaften Weiterbildung der Erfindung ist die erste Diodenanordnung so gepolt, dass sie vor und nach dem Trennen in Durchlassrichtung betrieben ist.

Gemäß einer zweckmäßigen Weiterbildung der Erfindung ist die zweite Diodenanordnung so gepolt, dass sie vor dem Trennen in Sperrrichtung und nach dem Trennen in Durchlassrichtung betrieben ist.

Nach einer vorteilhaften Weiterbildung der Erfindung umfasst der Trennschalter ein oder mehrere Halbleiterschalter. Prinzipiell könnte der Trennschalter auch als mechanischer Schalter ausgebildet sein. Allerdings ist es dabei nicht zu vermeiden, dass beim Trennen ein Lichtbogen entsteht, der die Messung verfälscht. Die Verwendung von Halbleiterschaltern vermeidet diesen Nachteil. Die Halbleiterschalter können parallel und/oder seriell geschaltet sein, um die Stromfestigkeit und/oder die Spannungsfestigkeit des Trennschalters zu erhöhen. Bei den Halbleiterschaltern kann es sich z.B. um MOSFETs, HEMTs, IGBTs, BJTs oder GTOs handeln.

Gemäß einer zweckmäßigen Weiterbildung der Erfindung ist ein zweites Ende der ersten Reihenschaltung mit dem zweiten Leiter der Energieversorgungsleitungsanordnung elektrisch verbunden. Hierdurch wird die im magnetischen Feld des quellseitigen Teils gespeicherte Energie vollständig in die erste kapazitive Anordnung überführt, was die Auswertung der ersten Spannungsänderung erleichtert.

Nach einer vorteilhaften Weiterbildung der Erfindung ist ein zweites Ende der ersten Reihenschaltung an der lastseitigen Seite des Trennschalters mit dem ersten Leiter elektrisch verbunden. Hierdurch ist die maximale Spannung an der ersten Reihenschaltung gegenüber den zuvor erläuterten Ausführungsbeispielen verringert, sodass die Anforderungen an die Spannungsfestigkeit ihrer Komponenten verringert sind.

Gemäß einer zweckmäßigen Weiterbildung der Erfindung ist ein zweites Ende der ersten Reihenschaltung mit einer elektrischen Verbindung zwischen der zweiten kapazitiven Anordnung und der zweiten Diodenanordnung elektrisch verbunden. Hierdurch ist die maximale Spannung an der ersten Reihenschaltung gegenüber den zuvor erläuterten Ausführungsbeispielen verringert, sodass die Anforderungen an die Spannungsfestigkeit ihrer Komponenten verringert sind.

Nach einer vorteilhaften Weiterbildung der Erfindung ist ein zweites Ende der zweiten Reihenschaltung mit dem zweiten Leiter der Energieversorgungsleitungsanordnung elektrisch verbunden. Hierdurch wird die im magnetischen Feld des lastseitigen Teils gespeicherte Energie vollständig in die zweite kapazitive Anordnung überführt, was die Auswertung der zweiten Spannungsänderung erleichtert.

Gemäß einer zweckmäßigen Weiterbildung der Erfindung ist ein zweites Ende der zweiten Reihenschaltung an der quellseitigen Seite des Trennschalters mit dem ersten Leiter elektrisch verbunden. Hierdurch ist die maximale Spannung an der zweiten Reihenschaltung gegenüber den zuvor erläuterten Ausführungsbeispielen verringert, sodass die Anforderungen an die Spannungsfestigkeit ihrer Komponenten verringert sind.

Nach einer vorteilhaften Weiterbildung der Erfindung ist ein zweites Ende der zweiten Reihenschaltung mit einer elektrischen Verbindung zwischen der ersten kapazitiven Anordnung und der ersten Diodenanordnung elektrisch verbunden. Hierdurch ist die maximale Spannung an der zweiten Reihenschaltung gegenüber den zuvor erläuterten Ausführungsbeispielen verringert, sodass die Anforderungen an die Spannungsfestigkeit ihrer Komponenten verringert sind.

Gemäß einer zweckmäßigen Weiterbildung der Erfindung weist die Großsignalinduktivitätsmesseinrichtung eine Entladeschaltung auf, welche zum Entladen der ersten kapazitiven Anordnung nach Abschluss des Messvorgangs ausgebildet ist, so dass nach Abschluss des Messvorgangs eine an der ersten kapazitiven Anordnung anliegende Spannung der Spannung der Energieversorgungsleitungsanordnung entspricht. Hierdurch kann die erste kapazitive Anordnung nach Abschluss des Messvorgangs in den Ausgangszustand zurückgebracht werden, sodass ein weiterer Messvorgang möglich wird. Die Entladeschaltung kann durch die Auswerteeinrichtung gesteuert sein.

Nach einer vorteilhaften Weiterbildung der Erfindung umfasst die erste kapazitive Anordnung eine Reihenschaltung aus ersten Kondensatoren, wobei die Entladeschaltung zum individuellen Entladen jedes der ersten Kondensatoren ausgebildet ist. Hierdurch können Messfehler verhindert werden, welche durch Abweichungen der Kapazitäten der ersten Kondensatoren von ihrem Nennwert entstehen könnten.

Gemäß einer zweckmäßigen Weiterbildung der Erfindung weist die Großsignalinduktivitätsmesseinrichtung eine Ladeschaltung auf, welche zum Laden der zweiten kapazitiven Anordnung nach Abschluss des Messvorgangs ausgebildet ist, so dass nach Abschluss des Messvorgangs eine an der zweiten kapazitiven Anordnung anliegende Spannung der Spannung der Energieversorgungsleitungsanordnung entspricht. Hierdurch kann die zweite kapazitive Anordnung nach Abschluss des Messvorgangs in den Ausgangszustand zurückgebracht werden, sodass ein weiterer Messvorgang möglich wird. Die Ladeschaltung kann durch die Auswerteeinrichtung gesteuert sein.

Nach einer vorteilhaften Weiterbildung der Erfindung umfasst die zweite Kondensatoranordnung eine Reihenschaltung aus zweiten Kondensatoren, wobei die Ladeschaltung zum individuellen Laden jedes der zweiten Kondensatoren ausgebildet ist. Hierdurch können Messfehler verhindert werden, welche durch Abweichungen der Kapazitäten der ersten Kondensatoren von ihrem Nennwert entstehen könnten.

Gemäß einer zweckmäßigen Weiterbildung der Erfindung ist die Großsignalinduktivitätsmesseinrichtung zum Schließen des Trennschalters nach Abschluss des Messvorgangs ausgebildet. Auf diese Weise wird ein weiterer Messvorgang möglich. Das Schließen des Trennschalters kann durch die Auswerteeinrichtung gesteuert sein.

Nach einer vorteilhaften Weiterbildung der Erfindung weist die Großsignalinduktivitätsmesseinrichtung eine Vorladeschaltung auf, welche zum Laden der Last vor dem Schließen des Trennschalters ausgebildet ist, sofern die Last kapazitiv ist. Auf diese Weise können hohe Einschaltströme verhindert werden. Die Vorladeschaltung kann parallel zum Trennschalter angeordnet und durch die Auswerteeinrichtung gesteuert sein.

In einem weiteren Aspekt wird die Aufgabe gelöst durch ein Verfahren zum Durchführen eines Messvorgangs zum Messen einer Induktivität an einer mit einer Gleichspannung betriebenen elektrischen Energieversorgungsleitungsanordnung mit einem ersten Leiter und mit einem zweiten Leiter mittels einer Großsignalinduktivitätsmesseinrichtung, wobei das Verfahren folgende Schritte umfasst:

Anordnen der Großsignalinduktivitätsmesseinrichtung zwischen einem ersten Abschnitt der Energieversorgungsleitungsanordnung, welcher mit einer elektrischen Energiequelle verbunden ist und einen quellseitigen Teil der Induktivität aufweist, und einem zweiten Abschnitt der Energieversorgungsleitungsanordnung, welcher mit einer elektrischen Last verbunden ist und einen lastseitigen Teil der Induktivität aufweist;

elektrisches Trennen des ersten Leiters der Energieversorgungsleitungsanordnung mittels eines Trennschalters;

Messen einer ersten Spannungsänderung an einer ersten kapazitiven Anordnung mittels einer ersten Messeinrichtung, wobei die erste Spannungsänderung mittels einer ersten Reihenschaltung umfassend die erste kapazitive Anordnung und eine erste Diodenanordnung erzeugt wird, wobei ein erstes Ende der ersten Reihenschaltung an einer quellseitigen Seite des Trennschalters mit dem ersten Leiter elektrisch verbunden ist, und welche derart ausgebildet ist, dass nach dem Trennen des ersten Leiters ein durch den quellseitigen Teil der Induktivität bewirkter erster Strom durch die erste Reihenschaltung fließt, der zu der ersten Spannungsänderung an der ersten kapazitiven Anordnung führt;

Messen einer zweiten Spannungsänderung an einer zweiten kapazitiven Anordnung mittels einer zweiten Messeinrichtung, wobei die zweite Spannungsänderung mittels einer zweiten Reihenschaltung umfassend die zweite kapazitive Anordnung und eine zweite Diodenanordnung erzeugt wird, wobei ein erstes Ende der zweiten Reihenschaltung an einer lastseitigen Seite des Trennschalters mit dem ersten Leiter elektrisch verbunden ist, und welche derart ausgebildet ist, dass nach dem Trennen des ersten Leiters ein durch den lastseitigen Teil der Induktivität bewirkter zweiter Strom durch die zweite Reihenschaltung fließt, der zu der zweiten Spannungsänderung an der zweiten kapazitiven Anordnung führt;

Messen eines dritten Stroms auf dem ersten Leiter vor dem Trennen des ersten Leiters mittels einer dritten Messeinrichtung; und

Auswerten der gemessenen ersten Spannungsänderung, der gemessenen zweiten Spannungsänderung und des gemessenen dritten Stroms mittels einer Auswerteeinrichtung, um aus der gemessenen ersten Spannungsänderung und aus dem gemessenen dritten Strom den quellseitigen Teil der Induktivität und um aus der gemessenen zweiten Spannungsänderung und aus dem gemessenen dritten Strom den lastseitigen Teil der Induktivität zu bestimmen.

Im Folgenden werden die vorliegende Erfindung und deren Vorteile anhand von Figuren näher beschrieben. Es zeigen:

Figur 1    ein erstes Ausführungsbeispiel einer erfindungsgemäßen Großsignalinduktivitätsmesseinrichtung in einer schematischen Darstellung;

Figur 2    einen zeitlichen Verlauf eines Stromes in dem quellseitigen Teil der Induktivität sowie den zeitlichen Verlauf einer ersten Spannungsänderung an der ersten kapazitiven Anordnung;

Figur 3    einen zeitlichen Verlauf eines Stromes in dem lastseitigen Teil der Induktivität sowie den zeitlichen Verlauf einer zweiten Spannungsänderung an der zweiten kapazitiven Anordnung;

Figur 4    ein zweites Ausführungsbeispiel einer erfindungsgemäßen Großsignalinduktivitätsmesseinrichtung in einer schematischen Darstellung;

Figur 5    ein drittes Ausführungsbeispiel einer erfindungsgemäßen Großsignalinduktivitätsmesseinrichtung in einer schematischen Darstellung;

Figur 6    ein viertes Ausführungsbeispiel einer erfindungsgemäßen Großsignalinduktivitätsmesseinrichtung in einer schematischen Darstellung;

Figur 7    ein fünftes Ausführungsbeispiel einer erfindungsgemäßen Großsignalinduktivitätsmesseinrichtung in einer schematischen Darstellung;

Figur 8    ein sechstes Ausführungsbeispiel einer erfindungsgemäßen Großsignalinduktivitätsmesseinrichtung in einer schematischen Darstellung;

Figur 9    ein siebtes Ausführungsbeispiel einer erfindungsgemäßen Großsignalinduktivitätsmesseinrichtung in einer schematischen Darstellung;

Figur 10   ein achtes Ausführungsbeispiel einer erfindungsgemäßen Großsignalinduktivitätsmesseinrichtung in einer schematischen Darstellung.

Gleiche oder gleichartige Elemente oder Elemente mit gleicher oder äquivalenter Funktion sind im Folgenden mit gleichen oder gleichartigen Bezugszeichen versehen.

In der folgenden Beschreibung werden Ausführungsbeispiele mit einer Vielzahl von Merkmalen der vorliegenden Erfindung näher beschrieben, um ein besseres Verständnis der Erfindung zu vermitteln. Es sei auch darauf hingewiesen, dass die in verschiedenen Ausführungsbeispielen gezeigten Merkmale auch in anderer Weise kombinierbar sind, sofern dies nicht ausdrücklich ausgeschlossen ist oder zu Widersprüchen führen würde.

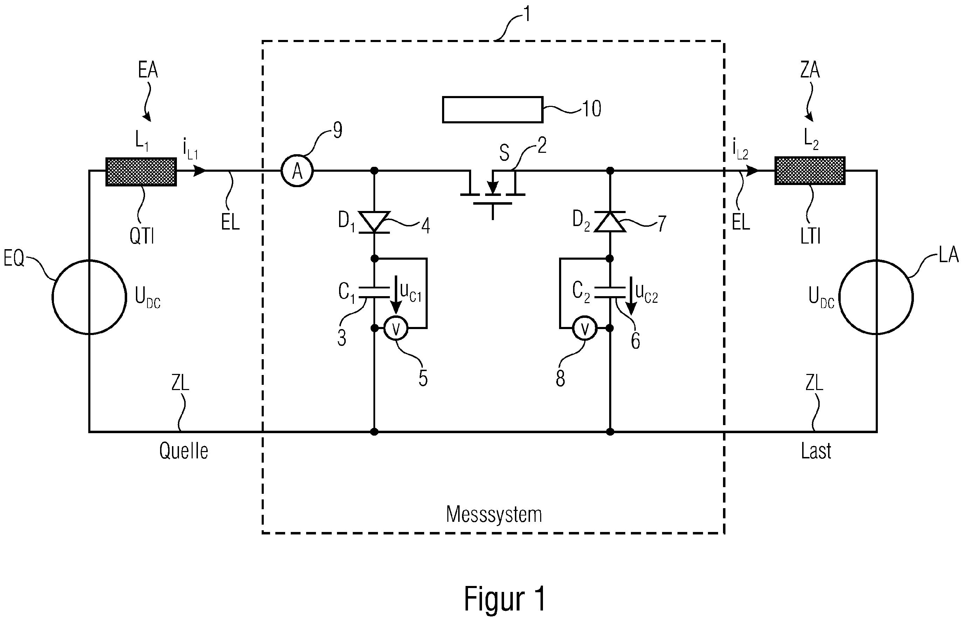

Figur 1 zeigt ein erstes Ausführungsbeispiel einer erfindungsgemäßen Großsignalinduktivitätsmesseinrichtung 1 in einer schematischen Darstellung. Die Großsignalinduktivitätsmesseinrichtung ist zum Durchführen eines Messvorgangs zum Messen einer Induktivität QTI, LTI an einer mit einer Gleichspannung betriebenen elektrischen Energieversorgungsleitungsanordnung EL, ZL mit einem ersten Leiter EL und mit einem zweiten Leiter ZL ausgebildet, wobei die Großsignalinduktivitätsmesseinrichtung 1 zum Anordnen zwischen einem ersten Abschnitt EA der Energieversorgungsleitungsanordnung EL, ZL, welcher mit einer elektrischen Energiequelle EQ verbunden ist und einen quellseitigen Teil der Induktivität QTI aufweist, und einem zweiten Abschnitt ZA der Energieversorgungsleitungsanordnung EL, ZL, welcher mit einer elektrischen Last LA verbunden ist und einen lastseitigen Teil der Induktivität LTI aufweist, ausgebildet ist. Die Großsignalinduktivitätsmesseinrichtung 1 umfasst:

einen Trennschalter 2 zum elektrischen Trennen des ersten Leiters EL der Energieversorgungsleitungsanordnung EL, ZL;

eine erste Reihenschaltung 3, 4 umfassend eine erste kapazitive Anordnung 3 und eine erste Diodenanordnung 4, wobei ein erstes Ende der ersten Reihenschaltung 3, 4 an einer quellseitigen Seite des Trennschalters 2 mit dem ersten Leiter EL elektrisch verbunden ist, und welche derart ausgebildet ist, dass nach dem Trennen des ersten Leiters EL ein durch den quellseitigen Teil der Induktivität QTI bewirkter erster Strom EST durch die erste Reihenschaltung 3, 4 fließt, der zu einer ersten Spannungsänderung ESA an der ersten kapazitiven Anordnung 3 führt;

eine erste Messeinrichtung 5 zum Messen der ersten Spannungsänderung ESA;

eine zweite Reihenschaltung 6, 7 umfassend eine zweite kapazitive Anordnung 6 und eine zweite Diodenanordnung 7, wobei ein erstes Ende der zweiten Reihenschaltung 6, 7 an einer lastseitigen Seite des Trennschalters 2 mit dem ersten Leiter EL elektrisch verbunden ist, und welche derart ausgebildet ist, dass nach dem Trennen des ersten Leiters EL ein durch den lastseitigen Teil der Induktivität LTI bewirkter zweiter Strom ZST durch die zweite Reihenschaltung 6, 7 fließt, der zu einer zweiten Spannungsänderung ZSA an der zweiten kapazitiven Anordnung 6 führt;

eine zweite Messeinrichtung 8 zum Messen der zweiten Spannungsänderung ZSA;

eine dritte Messeinrichtung 9 zum Messen eines dritten Stroms STR auf dem ersten Leiter EL vor dem Trennen des ersten Leiters EL; und

eine Auswerteeinrichtung 10 zum Auswerten der gemessenen ersten Spannungsänderung ESA, der gemessenen zweiten Spannungsänderung ZSA und des gemessenen dritten Stroms STR, um aus der gemessenen ersten Spannungsänderung ESA und aus dem gemessenen dritten Strom STR den quellseitigen Teil der Induktivität QTI und um aus der gemessenen zweiten Spannungsänderung ZSA und aus dem gemessenen dritten Strom STR den lastseitigen Teil der Induktivität LTI zu bestimmen.

Gemäß einer zweckmäßigen Weiterbildung der Erfindung ist die erste Diodenanordnung 3 so gepolt ist, dass sie vor und nach dem Trennen in Durchlassrichtung betrieben wird.

Nach einer vorteilhaften Weiterbildung der Erfindung ist die zweite Diodenanordnung 7 so gepolt ist, dass sie vor dem Trennen in Sperrrichtung und nach dem Trennen in Durchlassrichtung betrieben wird.

Gemäß einer zweckmäßigen Weiterbildung der Erfindung umfasst der Trennschalter 2 ein oder mehrere Halbleiterschalter.

Nach einer vorteilhaften Weiterbildung der Erfindung ist ein zweites Ende der ersten Reihenschaltung 3, 4 mit dem zweiten Leiter ZL der Energieversorgungsleitungsanordnung EL, ZL elektrisch verbunden.

Gemäß einer zweckmäßigen Weiterbildung der Erfindung ist ein zweites Ende der zweiten Reihenschaltung 6, 7 mit dem zweiten Leiter ZL der Energieversorgungsleitungsanordnung EL, ZL elektrisch verbunden.

Die Großsignalinduktivitätsmesseinrichtung 1 ist bidirektional ausgelegt, wobei Figur 1 den bestimmungsgemäßen Einsatz der Großsignalinduktivitätsmesseinrichtung 1 zeigt. Dabei ist die Großsignalinduktivitätsmesseinrichtung 1 zwischen einem ersten Abschnitt EA und einem zweiten Abschnitt ZA einer mit Gleichspannung betriebenen elektrischen Energieversorgungsleitungsanordnung EL, ZL mit einem ersten Leiter EL und mit einem zweiten Leiter ZL angeordnet. Dabei ist der Trennschalter 2 in den ersten Leiter EL eingefügt, während der zweite Leiter nicht unterbrochen ist.

Die erste Reihenschaltung 3, 4, welche aus der ersten kapazitiven Anordnung 3 und der ersten Diodenanordnung 4 besteht, ist an einem ersten Ende auf der quellseitigen Seite des Schalters 2 mit dem ersten Leiter EL elektrisch verbunden. Das zweite Ende der ersten Reihenschaltung 3, 4 ist mit dem zweiten Leiter ZL elektrisch verbunden. Die erste Diodenanordnung 4 ist dabei so gepolt, dass sie unabhängig vom Schaltzustand des Schalters 2 in Durchlassrichtung betrieben wird.

Die zweite Reihenschaltung 6, 7, welche aus der zweiten kapazitiven Anordnung 6 und der zweiten Diodenanordnung 7 besteht, ist an einem ersten Ende auf der lastseitigen Seite des Schalters mit dem ersten Leiter EL elektrisch verbunden. Das zweite Ende der zweiten Reihenschaltung 6, 7 ist mit dem zweiten Leiter ZL elektrisch verbunden. Die zweite Diodenanordnung 7 ist dabei so gepolt, dass sie bei geschlossenem Schalter 2 in Sperrrichtung und bei offenem Schalter 2 in Durchlassrichtung betrieben wird.

An den ersten Abschnitt EA der elektrischen Energieversorgungsleitungsanordnung EL, ZL ist eine Energiequelle EQ angeschlossen. Die Induktivitäten der Energiequelle EQ und des ersten Abschnitts EA der Energieversorgungsleitungsanordnung EL, ZL bilden dabei den quellseitigen Teil der Induktivität QTI. An den zweiten Abschnitt ZA der elektrischen Energieversorgungsleitungsanordnung EL, ZL ist eine elektrische Last LA angeschlossen. Die Induktivitäten der elektrischen Last LA und des zweiten Abschnitts ZA der Energieversorgungsleitungsanordnung EL, ZL bilden dabei den lastseitigen Teil der Induktivität LTI.

Die Großsignalinduktivitätsmesseinrichtung ermöglicht nun die Durchführung von Messvorgängen zum Messen des quellseitigen Teils der Induktivität QTI und zum Messen des lastseitigen Teils der Induktivität LTI. Bei einem Messvorgang ist der Trennschalter 2 zunächst im geschlossenen Zustand und zwar mindestens so lange, bis sich die gesamte Anordnung in einem eingeschwungenen Zustand befindet. Dabei wird der dritte Strom STR auf dem ersten Leiter EL mittels der dritten Messeinrichtung 9 gemessen. Die dritte Messeinrichtung 9 kann sich dabei an beliebiger Stelle des ersten Leiters EL befinden.

Nun wird der Trennschalter 2 geöffnet, sodass der quellseitige Abschnitt des ersten Leiters EL und der lastseitige Abschnitt des ersten Leiters EL nicht mehr direkt miteinander verbunden sind, sodass der Stromfluss zwischen der Energiequelle EQ und der Last LA unterbrochen ist. Durch die im Magnetfeld des quellseitigen Teils der Induktivität QTI gespeicherte Energie entsteht nun ein temporärer erster Strom EST durch die erste Reihenschaltung 3, 4, was zu einer ersten Spannungsänderung ESA an der ersten kapazitiven Anordnung 3 führt. Diese erste Spannungsänderung ESA wird mittels der ersten Messeinrichtung 5 gemessen. Durch die im Magnetfeld des lastseitigen Teils der Induktivität LTI gespeicherte Energie entsteht weiterhin ein temporärer zweiter Strom ZST durch die zweite Reihenschaltung 6, 7, was zu einer zweiten Spannungsänderung ZSA an der zweiten kapazitiven Anordnung 6 führt. Diese zweite Spannungsänderung ZSA wird mittels der zweiten Messeinrichtung 8 gemessen.

Der Wert $u_{C1}$ der elektrischen Spannung an der ersten kapazitiven Anordnung 3 steigt dabei über den Wert $U_{DC}$ der Spannung der Energiequelle EQ, woraufhin der Wert $i_{L1}$ des ersten Stroms EST sinkt bis er null wird und die Diodenanordnung 4 ein weiteres Absinken des ersten Stroms EST verhindert.

Die in dem quellseitigen Teil der Induktivität QTI gespeicherte Energie $E_{L1}$ lässt sich über den Wert $\Delta u_{C1}$ der ersten Spannungsänderung ESA nach Gleichung (1) berechnen, wobei $C_1$ die Kapazität der ersten kapazitiven Anordnung ist. Der Wert $L_{eq1}$ der äquivalenten linearen Induktivität, die bei gleichem Strom dieselbe Energie speichert, lässt sich nach Gleichung (2) berechnen.

$$E_{L1} = \frac{1}{2} C_1 \cdot (\Delta u_{C1})^2 \qquad (1)$$

$$L_{eq1} = \frac{2 E_{L1}}{(i_{L1}(t_0))^2} \qquad (2)$$

Der zur Last fließende zweite Strom ZST mit dem Wert $i_{L2}$ kommutiert vom Trennschalter 2 auf die zweite Reihenschaltung 6, 7. Die in dem lastseitigen Teil der Induktivität LTI gespeicherte Energie $E_{L2}$ lässt sich über den Wert $\Delta u_{C2}$ der zweiten Spannungsänderung ZSA nach Gleichung (3) berechnen, wobei $C_2$ die Kapazität der zweiten kapazitiven Anordnung ist. Auch hier lässt sich der Wert $L_{eq2}$ der äquivalenten linearen Induktivität nach Gleichung (4) bestimmen.

$$E_{L2} = \frac{1}{2} C_2 \cdot (\Delta u_{C2})^2 \qquad (3)$$

$$L_{eq2} = \frac{2\,E_{L2}}{(i_{L2}(t_0))^2} \qquad\qquad (4)$$

Die Summe der beiden Energien $E_{L1}$ und $E_{L2}$ entspricht der Energie, die in dem Lichtbogen eines mechanischen Ausschalters umgesetzt werden muss, der an der Position des Großsignalinduktivitätsmesseinrichtung 1 eingebaut wird. Durch die Separation der beiden Induktivitäten QTI und LTI können auf beiden Seiten des Ausschalters (zur Energiequelle EQ und zur Last LA) angepasste Lösungen zum Überlastschutz entworfen werden.

In einem weiteren Aspekt betrifft die Erfindung ein Verfahren zum Durchführen eines Messvorgangs zum Messen einer Induktivität QTI, LTI an einer mit einer Gleichspannung betriebenen elektrischen Energieversorgungsleitungsanordnung EL, ZL mit einem ersten Leiter EL und mit einem zweiten Leiter ZL mittels einer Großsignalinduktivitätsmesseinrichtung 1. Das Verfahren umfasst folgende Schritte: Anordnen der Großsignalinduktivitätsmesseinrichtung 1 zwischen einem ersten Abschnitt EA der Energieversorgungsleitungsanordnung EL, ZL, welcher mit einer elektrischen Energiequelle EQ verbunden ist und einen quellseitigen Teil der Induktivität QTI aufweist, und einem zweiten Abschnitt ZA der Energieversorgungsleitungsanordnung EL, ZL, welcher mit einer elektrischen Last LA verbunden ist und einen lastseitigen Teil der Induktivität LTI aufweist;

elektrisches Trennen des ersten Leiters EL der Energieversorgungsleitungsanordnung EL, ZL mittels eines Trennschalters 2;

Messen einer ersten Spannungsänderung ESA an einer ersten kapazitiven Anordnung 3 mittels einer ersten Messeinrichtung 5, wobei die erste Spannungsänderung ESA mittels einer ersten Reihenschaltung 3, 4 umfassend die erste kapazitive Anordnung 3 und eine erste Diodenanordnung 4 erzeugt wird, wobei ein erstes Ende der ersten Reihenschaltung 3, 4 an einer quellseitigen Seite des Trennschalters 2 mit dem ersten Leiter EL elektrisch verbunden ist, und welche derart ausgebildet ist, dass nach dem Trennen des ersten Leiters EL ein durch den quellseitigen Teil der Induktivität QTI bewirkter erster Strom EST durch die erste Reihenschaltung 3, 4 fließt, der zu der ersten Spannungsänderung ESA an der ersten kapazitiven Anordnung 3 führt;

Messen einer zweiten Spannungsänderung ZSA an einer zweiten kapazitiven Anordnung 6 mittels einer zweiten Messeinrichtung 8, wobei die zweite Spannungsänderung ZSA mittels einer zweiten Reihenschaltung 6, 7 umfassend die zweite kapazitive Anordnung 6 und eine zweite Diodenanordnung 7 erzeugt wird, wobei ein erstes Ende der zweiten Reihenschaltung 6, 7 an einer lastseitigen Seite des Trennschalters 2 mit dem ersten Leiter EL elektrisch verbunden ist, und welche derart ausgebildet ist, dass nach dem Trennen des ersten Leiters EL ein durch den lastseitigen Teil der Induktivität LTI bewirkter zweiter Strom ZST durch die zweite Reihenschaltung 6, 7 fließt, der zu der zweiten Spannungsänderung ZSA an der zweiten kapazitiven Anordnung 6 führt;

Messen eines dritten Stroms STR auf dem ersten Leiter EL vor dem Trennen des ersten Leiters EL mittels einer dritten Messeinrichtung 9; und

Auswerten der gemessenen ersten Spannungsänderung ESA, der gemessenen zweiten Spannungsänderung ZSA und des gemessenen dritten Stroms STR mittels einer Auswerteeinrichtung 10, um aus der gemessenen ersten Spannungsänderung ESA und aus dem gemessenen dritten Strom STR den quellseitigen Teil der Induktivität QTI und um aus der gemessenen zweiten Spannungsänderung ZSA und aus dem gemessenen dritten Strom STR den lastseitigen Teil der Induktivität LTI zu bestimmen.

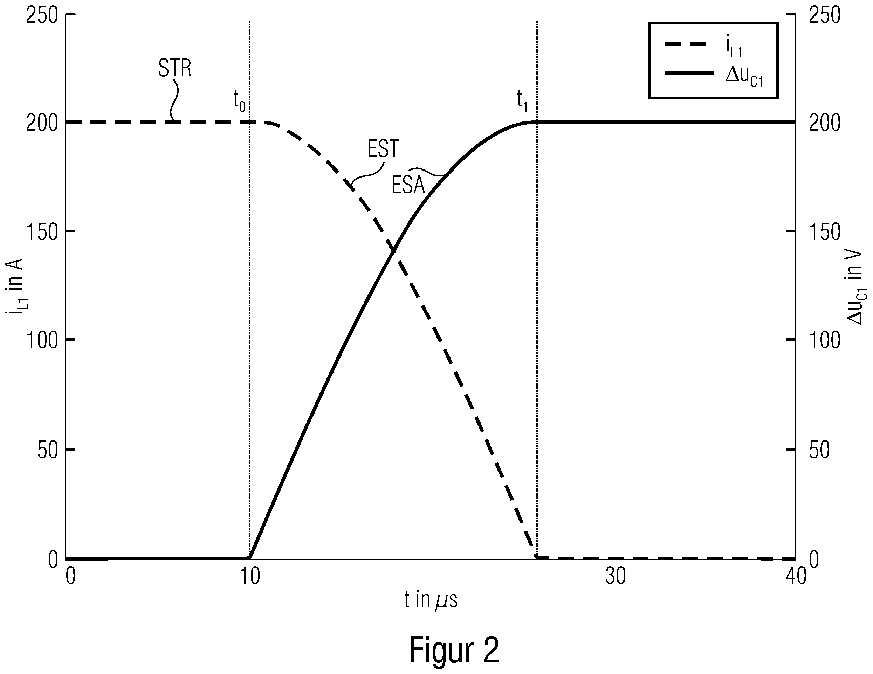

Figur 2 zeigt einen zeitlichen Verlauf eines Stromes STR, EST in dem quellseitigen Teil der Induktivität QTI sowie den zeitlichen Verlauf einer ersten Spannungsänderung ESA an der ersten kapazitiven Anordnung 3, wobei der Trennschalter 2 zum Zeitpunkt $t_0$ geöffnet wird. Zum Zeitpunkt $t_1$ ist die erste Spannungsänderung ESA abgeschlossen.

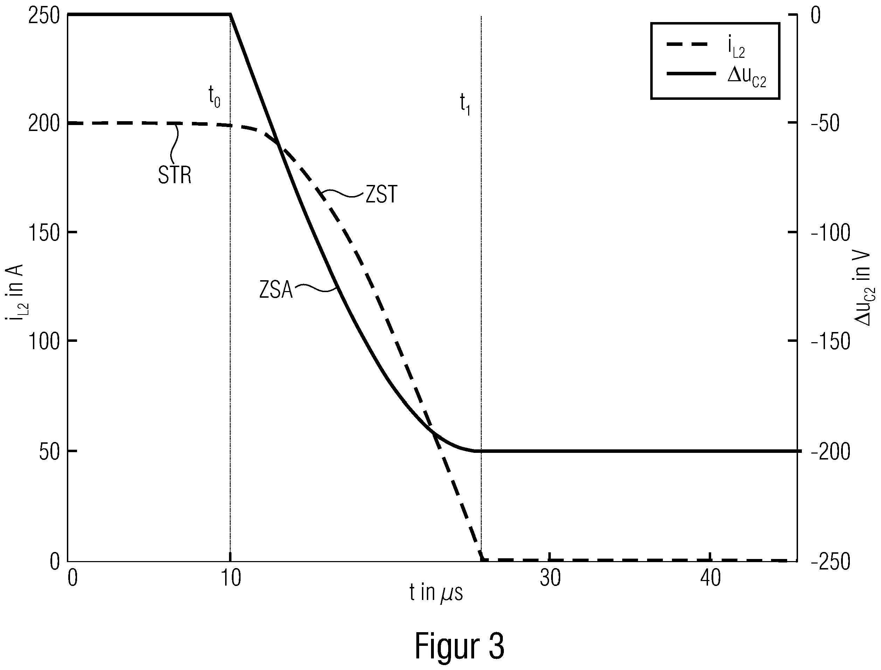

Figur 3 zeigt einen zeitlichen Verlauf eines Stromes STR, ZST in dem lastseitigen Teil der Induktivität LTI sowie den zeitlichen Verlauf einer zweiten Spannungsänderung ZSA an der zweiten kapazitiven Anordnung 6, wobei der Trennschalter 2 zum Zeitpunkt $t_0$ geöffnet wird. Zum Zeitpunkt $t_1$ ist die zweite Spannungsänderung ZSA abgeschlossen.

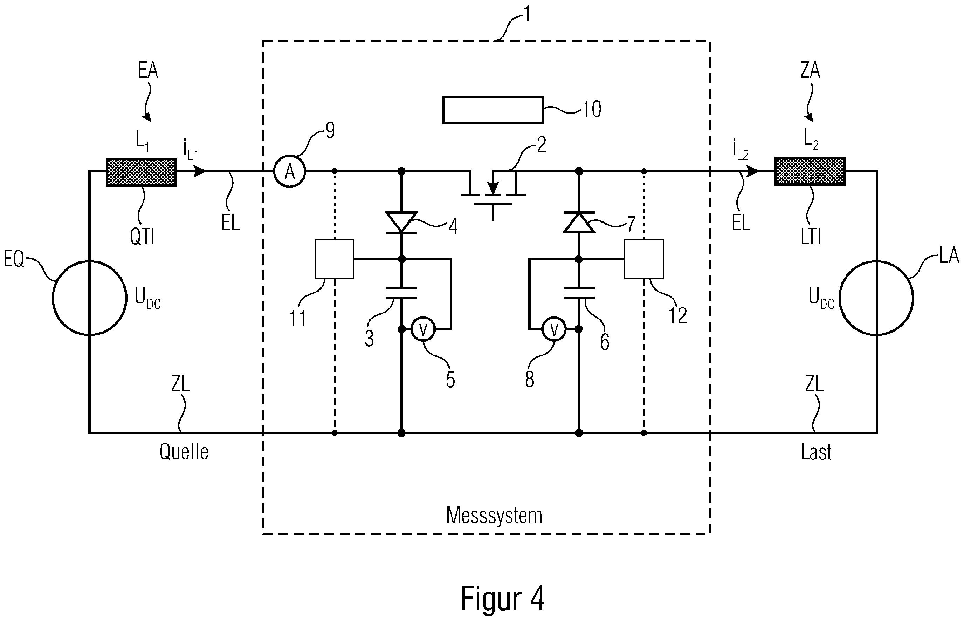

Figur 4 zeigt ein zweites Ausführungsbeispiel einer erfindungsgemäßen Großsignalinduktivitätsmesseinrichtung 1 in einer schematischen Darstellung. Das zweite Ausführungsbeispiel beruht auf dem ersten Ausführungsbeispiel, wobei im Folgenden lediglich die Unterschiede erläutert werden.

Nach einer vorteilhaften Weiterbildung der Erfindung weist die Großsignalinduktivitätsmesseinrichtung 1 eine Entladeschaltung 11 auf, welche zum Entladen der ersten kapazitiven Anordnung 3 nach Abschluss des Messvorgangs ausgebildet ist, so dass nach Abschluss des Messvorgangs eine an der ersten kapazitiven Anordnung 3 anliegende Spannung der Spannung der Energieversorgungsleitungsanordnung EL, ZL entspricht.

Nach einer zweckmäßigen Weiterbildung der Erfindung weist die Großsignalinduktivitätsmesseinrichtung 1 eine Ladeschaltung 12 auf, welche zum Laden der zweiten kapazitiven Anordnung 6 nach Abschluss des Messvorgangs ausgebildet ist, so dass nach Abschluss des Messvorgangs eine an der zweiten kapazitiven Anordnung 6 anliegende Spannung der Spannung der Energieversorgungsleitungsanordnung EL, ZL entspricht.

Nach einer vorteilhaften Weiterbildung der Erfindung ist die Großsignalinduktivitätsmesseinrichtung 1 zum Schließen des Trennschalters 2 nach Abschluss des Messvorgangs ausgebildet.

Um mehrere Messvorgänge hintereinander durchführen zu können, muss die Großsignalinduktivitätsmesseinrichtung 1 nach dem Messvorgang wieder in ihren Grundzustand gebracht werden. Das bedeutet, dass die Spannungen an der ersten kapazitiven Anordnung 3 und an der zweiten kapazitiven Anordnung 6 wieder der Spannung der Energiequelle EQ entsprechen müssen. Das Absinken der Spannung an der ersten kapazitiven Anordnung 3 wird allerdings durch die erste Diodenanordnung 4 verhindert. Daher ist eine Entladeschaltung 11 vorgesehen, welche die Spannung an der ersten kapazitiven Anordnung 3 abbaut. Gleichermaßen wird ein Ansteigen der Spannung an der zweiten kapazitiven Anordnung durch die zweite Diodenanordnung 7 verhindert. Daher ist zusätzlich eine Ladeschaltung 12 vorgesehen. Die prinzipielle Verschaltung ist in Figur 4 dargestellt.

Die Entladeschaltung 11 wird im Grundaufbau mit einer Verbindung zwischen der ersten Diodenanordnung 4 und der ersten kapazitiven Anordnung 3 verbunden. Außerdem kann sie mit dem ersten Leiter EL und/oder dem zweiten Leiter ZL verbunden werden. Der einfachste Aufbau einer Entladeschaltung ist ein ausreichend großer Widerstand, welcher die erste kapazitive Anordnung 3 nach dem Messvorgang langsam entlädt. Es sind jedoch auch aufwändigere Schaltungen, wie z.B. eine Kombination aus Widerstand und Diode, Widerstand und Schalter (mechanisch oder halbleiterbasiert), bis hin zu komplexen DC/DC-Konvertern, möglich. Gemeinsam haben diese Schaltungen jedoch die Aufgabe, die erste kapazitive Anordnung 3 wieder in den Grundzustand zu überführen. Das gleiche gilt für die Ladeschaltung 12, welche ebenfalls beliebig komplex aufgebaut werden kann und das Ziel hat, die zweite kapazitive Anordnung 6 in ihren Grundzustand zurück zu führen. Sie ist mit einer Verbindung zwischen der zweiten Diodenanordnung 7 und der zweiten kapazitiven Anordnung 6 verbunden. Außerdem kann sie mit dem ersten Leiter EL und/oder dem zweiten Leiter ZL verbunden werden.

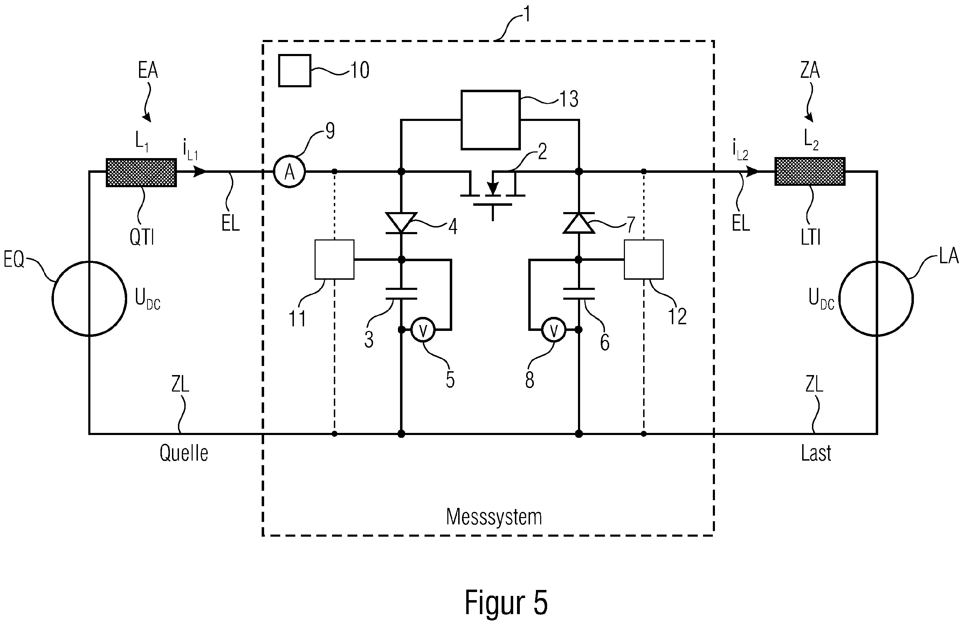

Figur 5 zeigt ein drittes Ausführungsbeispiel einer erfindungsgemäßen Großsignalinduktivitätsmesseinrichtung 1 in einer schematischen Darstellung.

Gemäß einer zweckmäßigen Weiterbildung der Erfindung weist die Großsignalinduktivitätsmesseinrichtung 1 eine Vorladeschaltung 13 auf, welche zum Laden der Last LA vor dem Schließen des Trennschalters 2 ausgebildet ist, sofern die Last kapazitiv ist.

Neben der Rückführung der ersten kapazitiven Anordnung 3 und der zweiten kapazitiven Anordnung 6 auf ihre Grundzustände, kann es auch notwendig sein, die Last LA auf die Spannung der Energiequelle EQ vorzuladen bevor ein weiterer Messvorgang durchgeführt werden kann. Dies kann in manchen Fällen durch ein Schalten des Trennschalters 2 ermöglicht werden. Ist die Last LA jedoch stark kapazitiv, kann ein einfaches Einschalten des Trennschalters 2 zu sehr hohen Einschaltströmen führen. Um diese zu begrenzen, kann die Messschaltung durch eine in Figur 5 gezeigte Vorladeschaltung 13 ergänzt werden, welche parallel zum Trennschalter angeordnet ist. Auch diese Vorladeschaltung 13 kann beliebig komplex ausgeführt werden. Sie hat jedoch immer das Ziel, die Spannung an der Last LA an die Spannung an der Energiequelle EQ anzupassen.

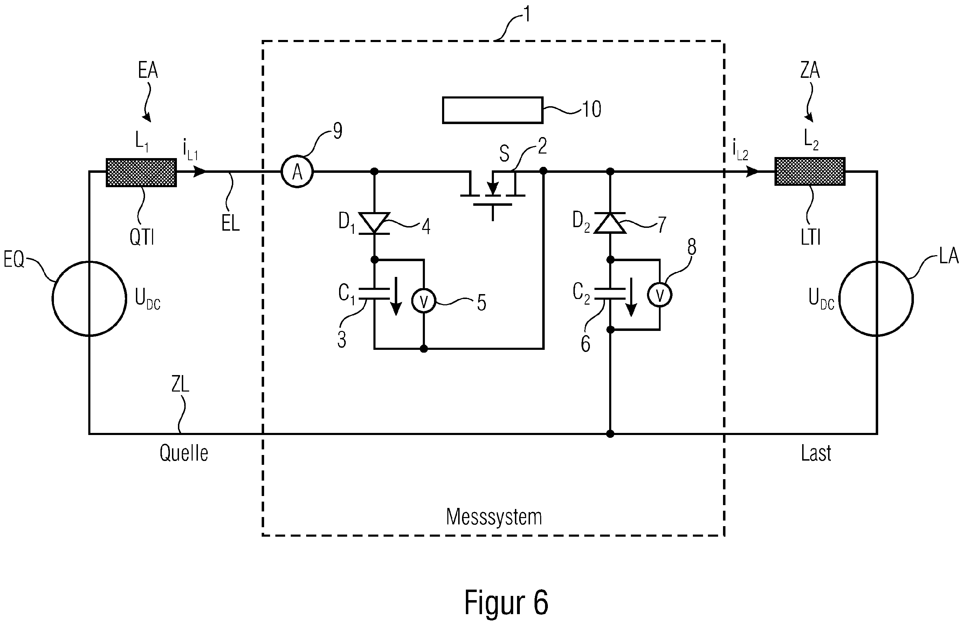

Figur 6 zeigt ein viertes Ausführungsbeispiel einer erfindungsgemäßen Großsignalinduktivitätsmesseinrichtung 1 in einer schematischen Darstellung. Das vierte Ausführungsbeispiel beruht auf dem ersten Ausführungsbeispiel, wobei im Folgenden lediglich die Unterschiede erläutert werden.

Gemäß einer zweckmäßigen Weiterbildung der Erfindung ist ein zweites Ende der ersten Reihenschaltung 3, 4 an der lastseitigen Seite des Trennschalters 2 mit dem ersten Leiter EL elektrisch verbunden.

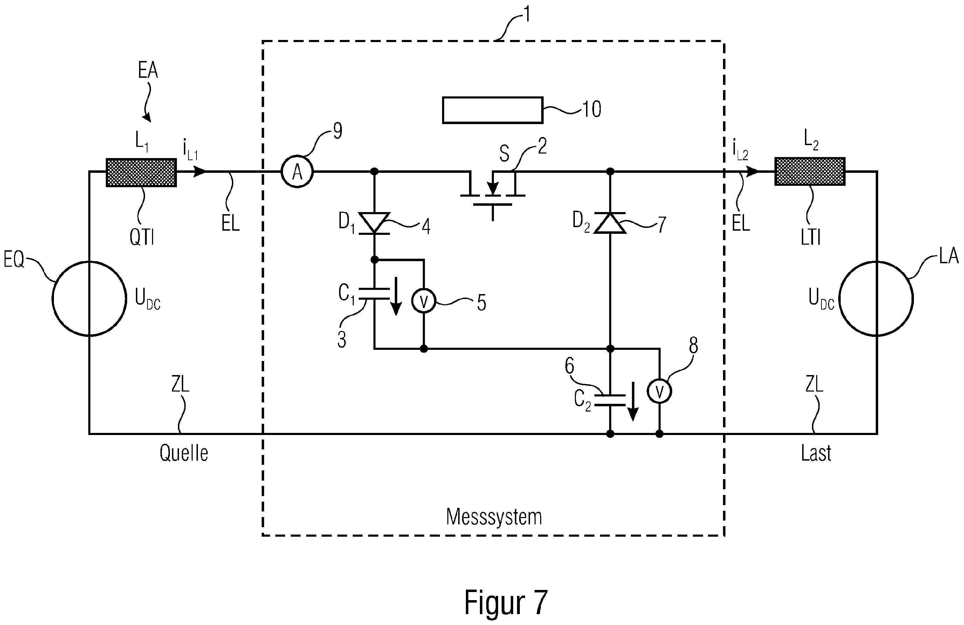

Figur 7 zeigt ein fünftes Ausführungsbeispiel einer erfindungsgemäßen Großsignalinduktivitätsmesseinrichtung 1 in einer schematischen Darstellung. Das fünfte Ausführungsbeispiel beruht auf dem ersten Ausführungsbeispiel, wobei im Folgenden lediglich die Unterschiede erläutert werden.

Nach einer vorteilhaften Weiterbildung der Erfindung ist ein zweites Ende der ersten Reihenschaltung 3, 4 mit einer elektrischen Verbindung zwischen der zweiten kapazitiven Anordnung 6 und der zweiten Diodenanordnung 7 elektrisch verbunden.

Beim vierten und beim fünften Ausführungsbeispiel ist die maximale Spannung an der ersten Reihenschaltung 3, 4 gegenüber den zuvor erläuterten Ausführungsbeispielen verringert, sodass die Anforderungen an die Spannungsfestigkeit ihrer Komponenten verringert sind.

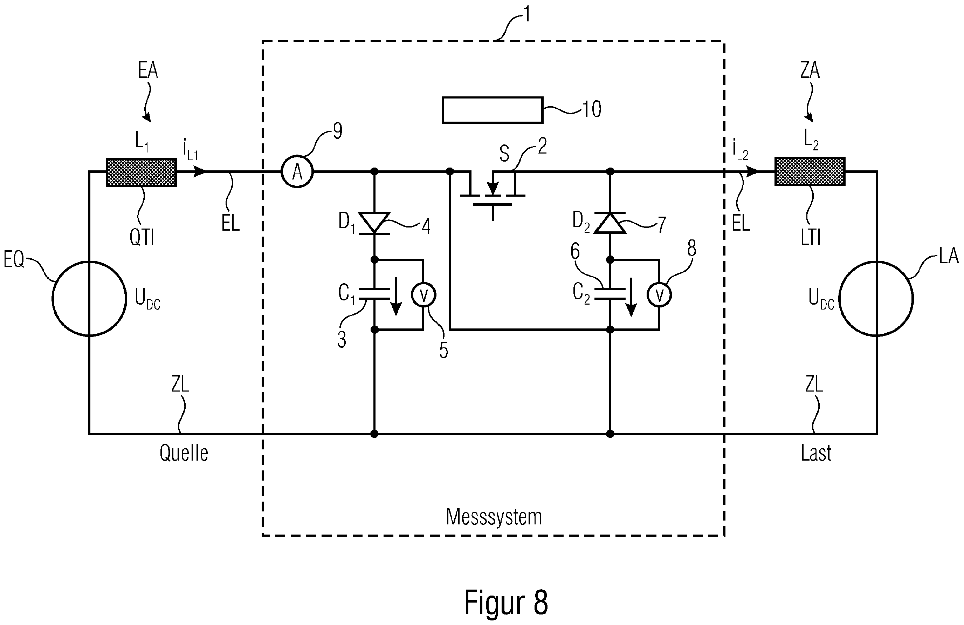

Figur 8 zeigt ein sechstes Ausführungsbeispiel einer erfindungsgemäßen Großsignalinduktivitätsmesseinrichtung 1 in einer schematischen Darstellung. Das sechste Ausführungsbeispiel beruht auf dem ersten Ausführungsbeispiel, wobei im Folgenden lediglich die Unterschiede erläutert werden.

Nach einer vorteilhaften Weiterbildung der Erfindung ist ein zweites Ende der zweiten Reihenschaltung 6, 7 an der quellseitigen Seite des Trennschalters 2 mit dem ersten Leiter EL elektrisch verbunden.

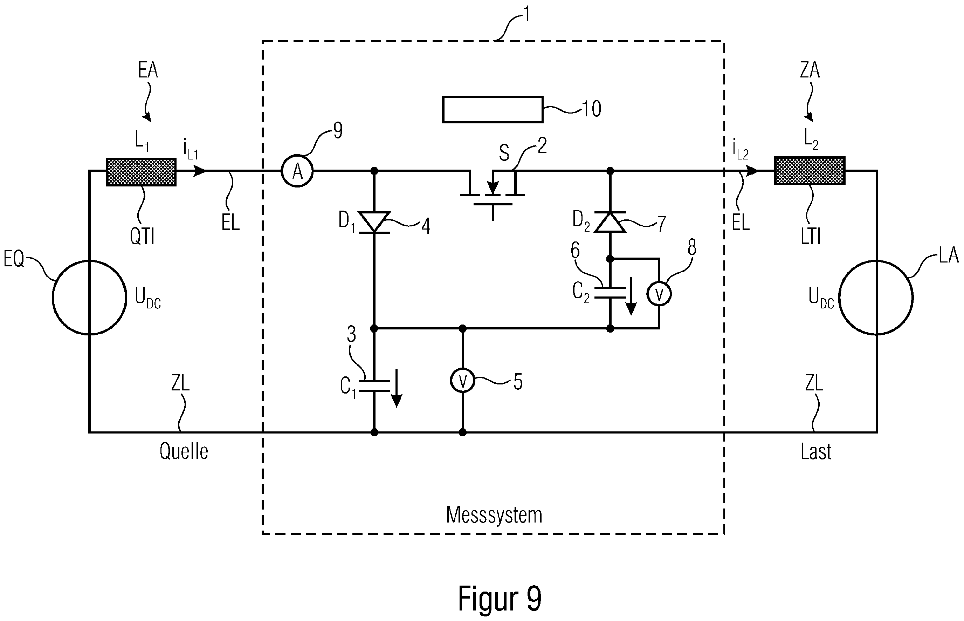

Figur 9 zeigt ein siebtes Ausführungsbeispiel einer erfindungsgemäßen Großsignalinduktivitätsmesseinrichtung 1 in einer schematischen Darstellung. Das siebte Ausführungsbeispiel beruht auf dem ersten Ausführungsbeispiel, wobei im Folgenden lediglich die Unterschiede erläutert werden.

Gemäß einer zweckmäßigen Weiterbildung der Erfindung ist ein zweites Ende der zweiten Reihenschaltung 6, 7 mit einer elektrischen Verbindung zwischen der ersten kapazitiven Anordnung 3 und der ersten Diodenanordnung 4 elektrisch verbunden.

Beim sechsten und beim siebten Ausführungsbeispiel ist die maximale Spannung an der zweiten Reihenschaltung 6, 7 gegenüber den zuvor erläuterten Ausführungsbeispielen verringert, sodass die Anforderungen an die Spannungsfestigkeit ihrer Komponenten verringert sind.

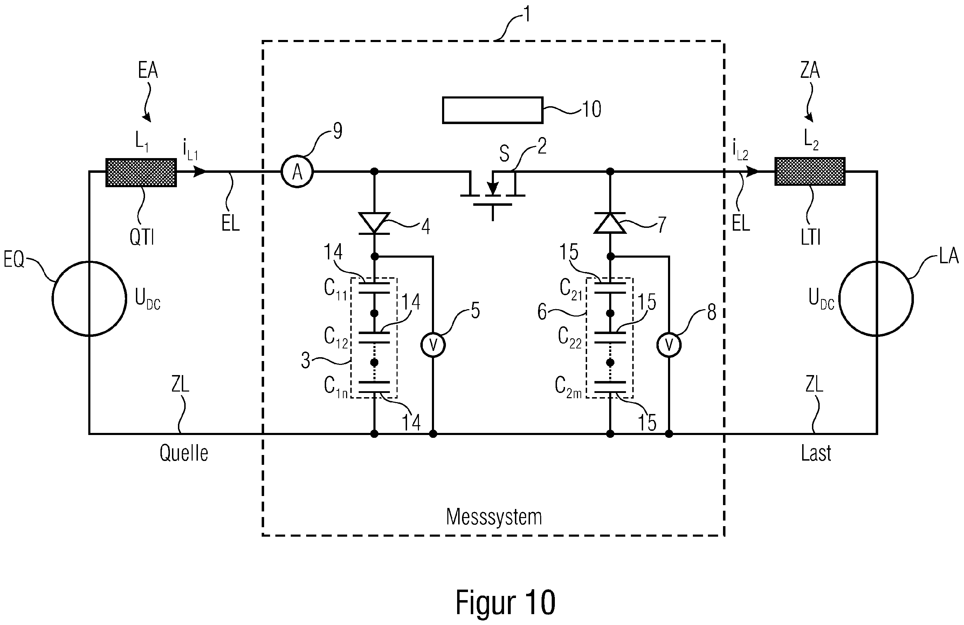

Figur 10 zeigt ein achtes Ausführungsbeispiel einer erfindungsgemäßen Großsignalinduktivitätsmesseinrichtung 1 in einer schematischen Darstellung. Das achte Ausführungsbeispiel beruht auf dem ersten Ausführungsbeispiel, wobei im Folgenden lediglich die Unterschiede erläutert werden. Die Entladeschaltung 11 und die Ladeschaltung 12 sind aus Platzgründen nicht dargestellt.

Gemäß einer zweckmäßigen Weiterbildung der Erfindung umfasst die erste kapazitive Anordnung 3 eine Reihenschaltung aus ersten Kondensatoren 14, wobei die Entladeschaltung 11 zum individuellen Entladen jedes der ersten Kondensatoren 14 ausgebildet ist.

Gemäß einer zweckmäßigen Weiterbildung der Erfindung umfasst die zweite kapazitive Anordnung 6 eine Reihenschaltung aus zweiten Kondensatoren 15, wobei die Ladeschaltung 12 zum individuellen Laden jedes der zweiten Kondensatoren 15 ausgebildet ist.

Wenn die erste kapazitive Anordnung 3 eine Reihenschaltung aus ersten Kondensatoren 14 umfasst und/oder wenn die zweite kapazitive Anordnung 6 eine Reihenschaltung aus zweiten Kondensatoren 15 umfasst, ergibt sich ein weiteres Optimierungspotential. So ergibt sich die Möglichkeit auf die Potentiale zwischen den in Reihe geschalteten ersten Kondensatoren 14 mittels der Entladeschaltung 11 gezielt einzuwirken. Ebenfalls ergibt sich die Möglichkeit auf die Potentiale zwischen den in Reihe geschalteten zweiten Kondensatoren 15 mittels der Ladeschaltung 12 gezielt einzuwirken. Hierzu ist die Entladeschaltung 11 mit jeder Elektrode der ersten Kondensatoren 14 und optional mit dem ersten Leiter EL und/oder dem zweiten Leiter ZL verbunden. Analog ist die Ladeschaltung 12 mit jeder Elektrode der zweiten Kondensatoren 15 und optional mit dem ersten Leiter EL und oder dem zweiten Leiter ZL verbunden.

Aspekte, welche im Zusammenhang mit einer Vorrichtung beschrieben sind, betreffen auch korrespondierende Verfahren. Umgekehrt betreffen auch solche Aspekte, welche im Zusammenhang mit einem Verfahren beschrieben sind, auch eine korrespondierende Vorrichtung.

Bezugszeichen:

1    Großsignalinduktivitätsmesseinrichtung
2    Trennschalter
3    erste kapazitive Anordnung
4    erste Diodenanordnung
5    erste Messeinrichtung
6    zweite kapazitive Anordnung
7    zweite Diodenanordnung
8    zweite Messeinrichtung
9    dritte Messeinrichtung
10   Auswerteeinrichtung
11   Entladeschaltung
12   Ladeschaltung
13   Vorladeschaltung
14   erste Kondensatoren
15   zweite Kondensatoren

QTI   quellseitiger Teil der Induktivität
LTI   lastseitiger Teil der Induktivität
EL    erster Leiter
ZL    zweiter Leiter
EA    erster Abschnitt
EQ    Energiequelle
ZA    zweiter Abschnitt
LA    Last

**EP 4 141 455 B1**

ESA    erste Spannungsänderung
EST    erster Strom
ZSA    zweite Spannungsänderung
ZST    zweiter Strom
STR    dritter Strom

Quellen:

[1] US 4,458,196 A.
[2] EP 3 422 029 A1.
[3] US 2014/0019075 A1.
[4] DE 3342378 A1.
[5] US 2014/0028331 A1.
[6] A. Kulka und T. Underland, "Grid Inductance Estimation by Reactive Power Perturbation", Nordic Workshop on Power and Industrial Electronics, 11 06 2008.
[7] A. Timbus, R. Teodorescu und F. Blaabjerg, "Online Grid Impedance Measurement Suitable for Multiple PV Inverters Running in Parallel," Twenty-First Annual IEEE Applied Power Electronics Conference and Exposition, 2006.
[8] US 1058795652 B2.
[9] WO 2020/089462 A1

**Patentansprüche**

1.  Großsignalinduktivitätsmesseinrichtung zum Durchführen eines Messvorgangs zum Messen einer Induktivität (QTI, LTI) an einer mit einer Gleichspannung betriebenen elektrischen Energieversorgungsleitungsanordnung (EL, ZL) mit einem ersten Leiter (EL) und mit einem zweiten Leiter (ZL), wobei die Großsignalinduktivitätsmesseinrichtung (1) zum Anordnen zwischen einem ersten Abschnitt (EA) der Energieversorgungsleitungsanordnung (EL, ZL), welcher mit einer elektrischen Energiequelle (EQ) verbunden ist und einen quellseitigen Teil der Induktivität (QTI) aufweist, und einem zweiten Abschnitt (ZA) der Energieversorgungsleitungsanordnung (EL, ZL), welcher mit einer elektrischen Last (LA) verbunden ist und einen lastseitigen Teil der Induktivität (LTI) aufweist, ausgebildet ist; die Großsignalinduktivitätsmesseinrichtung (1) umfassend:

    einen Trennschalter (2) zum elektrischen Trennen des ersten Leiters (EL) der Energieversorgungsleitungsanordnung (EL, ZL);
    eine erste Reihenschaltung (3, 4) umfassend eine erste kapazitive Anordnung (3) und eine erste Diodenanordnung (4), wobei ein erstes Ende der ersten Reihenschaltung (3, 4) an einer quellseitigen Seite des Trennschalters (2) mit dem ersten Leiter (EL) elektrisch verbunden ist, und welche derart ausgebildet ist, dass nach dem Trennen des ersten Leiters (EL) ein durch den quellseitigen Teil der Induktivität (QTI) bewirkter erster Strom (EST) durch die erste Reihenschaltung (3, 4) fließt, der zu einer ersten Spannungsänderung (ESA) an der ersten kapazitiven Anordnung (3) führt;
    eine erste Messeinrichtung (5) zum Messen der ersten Spannungsänderung (ESA);
    eine zweite Reihenschaltung (6, 7) umfassend eine zweite kapazitive Anordnung (6) und eine zweite Diodenanordnung (7), wobei ein erstes Ende der zweiten Reihenschaltung (6, 7) an einer lastseitigen Seite des Trennschalters (2) mit dem ersten Leiter (EL) elektrisch verbunden ist, und welche derart ausgebildet ist, dass nach dem Trennen des ersten Leiters (EL) ein durch den lastseitigen Teil der Induktivität (LTI) bewirkter zweiter Strom (ZST) durch die zweite Reihenschaltung (6, 7) fließt, der zu einer zweiten Spannungsänderung (ZSA) an der zweiten kapazitiven Anordnung (6) führt;
    eine zweite Messeinrichtung (8) zum Messen der zweiten Spannungsänderung (ZSA);
    eine dritte Messeinrichtung (9) zum Messen eines dritten Stroms (STR) auf dem ersten Leiter (EL) vor dem Trennen des ersten Leiters (EL); und
    eine Auswerteeinrichtung (10) zum Auswerten der gemessenen ersten Spannungsänderung (ESA), der gemessenen zweiten Spannungsänderung (ZSA) und des gemessenen dritten Stroms (STR), um aus der gemessenen ersten Spannungsänderung (ESA) und aus dem gemessenen dritten Strom (STR) den quellseitigen Teil der Induktivität (QTI) und um aus der gemessenen zweiten Spannungsänderung (ZSA) und aus dem gemessenen dritten Strom (STR) den lastseitigen Teil der Induktivität (LTI) zu bestimmen.

**2.** Großsignalinduktivitätsmesseinrichtung nach vorstehendem Anspruch, wobei die erste Diodenanordnung (3) so gepolt ist, dass sie vor und nach dem Trennen in Durchlassrichtung betrieben ist.

**3.** Großsignalinduktivitätsmesseinrichtung nach einem der vorstehenden Ansprüche, wobei die zweite Diodenanordnung (7) so gepolt ist, dass sie vor dem Trennen in Sperrrichtung und nach dem Trennen in Durchlassrichtung betrieben ist.

**4.** Großsignalinduktivitätsmesseinrichtung nach einem der vorstehenden Ansprüche, wobei der Trennschalter (2) ein oder mehrere Halbleiterschalter umfasst.

**5.** Großsignalinduktivitätsmesseinrichtung nach einem der vorstehenden Ansprüche, wobei ein zweites Ende der ersten Reihenschaltung (3, 4) mit dem zweiten Leiter (ZL) der Energieversorgungsleitungsanordnung (EL, ZL) elektrisch verbunden ist.

**6.** Großsignalinduktivitätsmesseinrichtung nach einem der Ansprüche 1 bis 4, wobei ein zweites Ende der ersten Reihenschaltung (3, 4) an der lastseitigen Seite des Trennschalters (2) mit dem ersten Leiter (EL) elektrisch verbunden ist.

**7.** Großsignalinduktivitätsmesseinrichtung nach einem der Ansprüche 1 bis 4, wobei ein zweites Ende der ersten Reihenschaltung (3, 4) mit einer elektrischen Verbindung zwischen der zweiten kapazitiven Anordnung (6) und der zweiten Diodenanordnung (7) elektrisch verbunden ist.

**8.** Großsignalinduktivitätsmesseinrichtung nach einem der vorstehenden Ansprüche, wobei ein zweites Ende der zweiten Reihenschaltung (6, 7) mit dem zweiten Leiter (ZL) der Energieversorgungsleitungsanordnung (EL, ZL) elektrisch verbunden ist.

**9.** Großsignalinduktivitätsmesseinrichtung nach einem der Ansprüche 1 bis 5, wobei ein zweites Ende der zweiten Reihenschaltung (6, 7) an der quellseitigen Seite des Trennschalters (2) mit dem ersten Leiter (EL) elektrisch verbunden ist.

**10.** Großsignalinduktivitätsmesseinrichtung nach einem der Ansprüche 1 bis 5, wobei ein zweites Ende der zweiten Reihenschaltung (6, 7) mit einer elektrischen Verbindung zwischen der ersten kapazitiven Anordnung (3) und der ersten Diodenanordnung (4) elektrisch verbunden ist.

**11.** Großsignalinduktivitätsmesseinrichtung nach einem der vorstehenden Ansprüche, wobei die Großsignalinduktivitätsmesseinrichtung (1) eine Entladeschaltung (11) aufweist, welche zum Entladen der ersten kapazitiven Anordnung (3) nach Abschluss des Messvorgangs ausgebildet ist, so dass nach Abschluss des Messvorgangs eine an der ersten kapazitiven Anordnung (3) anliegende Spannung der Spannung der Energieversorgungsleitungsanordnung (EL, ZL) entspricht.

**12.** Großsignalinduktivitätsmesseinrichtung nach vorstehendem Anspruch, wobei die erste kapazitive Anordnung (3) eine Reihenschaltung aus ersten Kondensatoren (14) umfasst, wobei die Entladeschaltung (11) zum individuellen Entladen jedes der ersten Kondensatoren (14) ausgebildet ist.

**13.** Großsignalinduktivitätsmesseinrichtung nach einem der vorstehenden Ansprüche, wobei die Großsignalinduktivitätsmesseinrichtung (1) eine Ladeschaltung (12) aufweist, welche zum Laden der zweiten kapazitiven Anordnung (6) nach Abschluss des Messvorgangs ausgebildet ist, so dass nach Abschluss des Messvorgangs eine an der zweiten kapazitiven Anordnung (6) anliegende Spannung der Spannung der Energieversorgungsleitungsanordnung (EL, ZL) entspricht.

**14.** Großsignalinduktivitätsmesseinrichtung nach vorstehendem Anspruch, wobei die zweite kapazitive Anordnung (6) eine Reihenschaltung aus zweiten Kondensatoren (15) umfasst, wobei die Ladeschaltung (12) zum individuellen Laden jedes der zweiten Kondensatoren (15) ausgebildet ist.

**15.** Großsignalinduktivitätsmesseinrichtung nach einem der vorstehenden Ansprüche, wobei die Großsignalinduktivitätsmesseinrichtung (1) zum Schließen des Trennschalters (2) nach Abschluss des Messvorgangs ausgebildet ist.

**16.** Großsignalinduktivitätsmesseinrichtung nach vorstehendem Anspruch, wobei die Großsignalinduktivitätsmesseinrichtung (1) eine Vorladeschaltung (13) aufweist, welche zum Laden der Last (LA) vor dem Schließen des Trennschalters (2) ausgebildet ist, sofern die Last kapazitiv ist.

17. Verfahren zum Durchführen eines Messvorgangs zum Messen einer Induktivität (QTI, LTI) an einer mit einer Gleichspannung betriebenen elektrischen Energieversorgungsleitungsanordnung (EL, ZL) mit einem ersten Leiter (EL) und mit einem zweiten Leiter (ZL) mittels einer Großsignalinduktivitätsmesseinrichtung (1), wobei das Verfahren folgende Schritte umfasst:

Anordnen der Großsignalinduktivitätsmesseinrichtung (1) zwischen einem ersten Abschnitt (EA) der Energieversorgungsleitungsanordnung (EL, ZL), welcher mit einer elektrischen Energiequelle (EQ) verbunden ist und einen quellseitigen Teil der Induktivität (QTI) aufweist, und einem zweiten Abschnitt (ZA) der Energieversorgungsleitungsanordnung (EL, ZL), welcher mit einer elektrischen Last (LA) verbunden ist und einen lastseitigen Teil der Induktivität (LTI) aufweist;

elektrisches Trennen des ersten Leiters (EL) der Energieversorgungsleitungsanordnung (EL, ZL) mittels eines Trennschalters (2);

Messen einer ersten Spannungsänderung (ESA) an einer ersten kapazitiven Anordnung (3) mittels einer ersten Messeinrichtung (5), wobei die erste Spannungsänderung (ESA) mittels einer ersten Reihenschaltung (3, 4) umfassend die erste kapazitive Anordnung (3) und eine erste Diodenanordnung (4) erzeugt wird, wobei ein erstes Ende der ersten Reihenschaltung (3, 4) an einer quellseitigen Seite des Trennschalters (2) mit dem ersten Leiter (EL) elektrisch verbunden ist, und welche derart ausgebildet ist, dass nach dem Trennen des ersten Leiters (EL) ein durch den quellseitigen Teil der Induktivität (QTI) bewirkter erster Strom (EST) durch die erste Reihenschaltung (3, 4) fließt, der zu der ersten Spannungsänderung (ESA) an der ersten kapazitiven Anordnung (3) führt;

Messen einer zweiten Spannungsänderung (ZSA) an einer zweiten kapazitiven Anordnung (6) mittels einer zweiten Messeinrichtung (8), wobei die zweite Spannungsänderung (ZSA) mittels einer zweiten Reihenschaltung (6, 7) umfassend die zweite kapazitive Anordnung (6) und eine zweite Diodenanordnung (7) erzeugt wird, wobei ein erstes Ende der zweiten Reihenschaltung (6, 7) an einer lastseitigen Seite des Trennschalters (2) mit dem ersten Leiter (EL) elektrisch verbunden ist, und welche derart ausgebildet ist, dass nach dem Trennen des ersten Leiters (EL) ein durch den lastseitigen Teil der Induktivität (LTI) bewirkter zweiter Strom (ZST) durch die zweite Reihenschaltung (6, 7) fließt, der zu der zweiten Spannungsänderung (ZSA) an der zweiten kapazitiven Anordnung (6) führt;

Messen eines dritten Stroms (STR) auf dem ersten Leiter (EL) vor dem Trennen des ersten Leiters (EL) mittels einer dritten Messeinrichtung (9); und

Auswerten der gemessenen ersten Spannungsänderung (ESA), der gemessenen zweiten Spannungsänderung (ZSA) und des gemessenen dritten Stroms (STR) mittels einer Auswerteeinrichtung (10), um aus der gemessenen ersten Spannungsänderung (ESA) und aus dem gemessenen dritten Strom (STR) den quellseitigen Teil der Induktivität (QTI) und um aus der gemessenen zweiten Spannungsänderung (ZSA) und aus dem gemessenen dritten Strom (STR) den lastseitigen Teil der Induktivität (LTI) zu bestimmen.

**Claims**

1. Large-signal inductance measuring device for performing a measuring operation for measuring an inductance (QTI, LTI) at an electrical energy supply line arrangement (EL, ZL) operated with a DC voltage and having a first conductor (EL) and a second conductor (ZL), wherein the large-signal inductance measuring device (1) is configured for arrangement between a first portion (EA) of the energy supply line arrangement (EL, ZL), which is connected to an electrical energy source (EQ) and comprises a source-side part of the inductance (QTI), and a second portion (ZA) of the energy supply line arrangement (EL, ZL), which is connected to an electrical load (LA) and comprises a load-side part of the inductance (LTI); the large-signal inductance measuring device (1) including:

a disconnecting switch (2) for electrically disconnecting the first conductor (EL) of the energy supply line arrangement (EL, ZL);

a first series circuit (3, 4) including a first capacitive arrangement (3) and a first diode arrangement (4), wherein a first end of the first series circuit (3, 4) is electrically connected to the first conductor (EL) at a source-side side of the disconnecting switch (2), and which is configured such that, after disconnecting the first conductor (EL), a first current (EST) caused by the source-side part of the inductance (QTI) flows through the first series circuit (3, 4), which current (EST) leads to a first change in voltage (ESA) at the first capacitive arrangement (3);

a first measuring device (5) for measuring the first change in voltage (ESA);

a second series circuit (6, 7) including a second capacitive arrangement (6) and a second diode arrangement (7), wherein a first end of the second series circuit (6, 7) is electrically connected to the first conductor (EL) at a load-side side of the disconnecting switch (2), and which is configured such that, after disconnecting the first conductor (EL), a second current (ZST) caused by the load-side part of the inductance (LTI) flows through the second series circuit (6, 7), which current (ZST) leads to a second change in voltage (ZSA) at the second capacitive arrangement (6);

a second measuring device (8) for measuring the second change in voltage (ZSA);

a third measuring device (9) for measuring a third current (STR) on the first conductor (EL) before the first conductor (EL) is disconnected; and

an evaluation device (10) for evaluating the measured first change in voltage (ESA), the measured second change in voltage (ZSA), and the measured third current (STR) in order to determine the source-side part of the inductance (QTI) from the measured first change in voltage (ESA) and from the measured third current (STR), and in order to determine the load-side part of the inductance (LTI) from the measured second change in voltage (ZSA) and from the measured third current (STR).

2. Large-signal inductance measuring device according to the preceding claim, wherein the first diode arrangement (3) is polarized such that it is forward-biased before and after disconnecting.

3. Large-signal inductance measuring device according to any one of the preceding claims, wherein the second diode arrangement (7) is polarized such that it is reverse-biased before disconnecting and forward-biased after disconnecting.

4. Large-signal inductance measuring device according to any one of the preceding claims, wherein the disconnecting switch (2) includes one or several semiconductor switches.

5. Large-signal inductance measuring device according to any one of the preceding claims, wherein a second end of the first series circuit (3, 4) is electrically connected to the second conductor (ZL) of the energy supply line arrangement (EL, ZL).

6. Large-signal inductance measuring device according to any one of claims 1 to 4, wherein a second end of the first series circuit (3, 4) is electrically connected to the first conductor (EL) at the load-side side of the disconnecting switch (2).

7. Large-signal inductance measuring device according to any one of claims 1 to 4, wherein a second end of the first series circuit (3, 4) is electrically connected to an electrical connection between the second capacitive arrangement (6) and the second diode arrangement (7).

8. Large-signal inductance measuring device according to any one of the preceding claims, wherein a second end of the second series circuit (6, 7) is electrically connected to the second conductor (ZL) of the energy supply line arrangement (EL, ZL).

9. Large-signal inductance measuring device according to any one of claims 1 to 5, wherein a second end of the second series circuit (6, 7) is connected to the first conductor (EL) at the source-side side of the disconnecting switch (2).

10. Large-signal inductance measuring device according to any one of claims 1 to 5, wherein a second end of the second series circuit (6, 7) is electrically connected to an electrical connection between the first capacitive arrangement (3) and the first diode arrangement (4).

11. Large-signal inductance measuring device according to any one of the preceding claims, wherein the large-signal inductance measuring device (1) comprises a discharging circuit (11) which is configured to discharge the first capacitive arrangement (3) after completion of the measuring operation, so that after completion of the measuring operation, a voltage applied to the first capacitive arrangement (3) matches the voltage of the energy supply line arrangement (EL, ZL).

12. Large-signal inductance measuring device according to the preceding claim, wherein the first capacitive arrangement (3) includes a series circuit of first capacitors (14), wherein the discharging circuit (11) is configured to individually discharge each of the first capacitors (14).

13. Large-signal inductance measuring device according to any one of the preceding claims, wherein the large-signal inductance measuring device (1) comprises a charging circuit (12) which is configured to charge the second capacitive arrangement (6) after completion of the measuring operation, so that after completion of the measuring operation, a voltage applied to the second capacitive arrangement (6) matches the voltage of the energy supply line arrangement (EL, ZL).

14. Large-signal inductance measuring device according to the preceding claim, wherein the second capacitive arrangement (6) includes a series circuit of second capacitors (15), wherein the charging circuit (12) is configured to individually charge each of the second capacitors (15).

15. Large-signal inductance measuring device according to any one of the preceding claims, wherein the large-signal inductance measuring device (1) is configured to close the disconnecting switch (2) after completion of the measuring operation.

16. Large-signal inductance measuring device according to the preceding claim, wherein the large-signal inductance measuring device (1) comprises a precharging circuit (13) which is configured to charge the load (LA) before the disconnecting switch (2) is closed, provided that the load is capacitive.

17. Method for performing a measuring operation for measuring an inductance (QTI, LTI) at an electrical energy supply line arrangement (EL, ZL) operated with DC voltage and having a first conductor (EL) and a second conductor (ZL), by means of a large-signal inductance measuring device (1), the method comprising:

arranging the large-signal inductance measuring device (1) between a first portion (EA) of the energy supply line arrangement (EL, ZL), which is connected to an electrical energy source (EQ) and comprises a source-side part of the inductance (QTI), and a second portion (ZA) of the energy supply line arrangement (EL, ZL), which is connected to an electrical load (LA) and comprises a load-side part of the inductance (LTI);
electrically disconnecting the first conductor (EL) of the energy supply line arrangement (EL, ZL) by means of a disconnecting switch (2);
measuring a first change in voltage (ESA) at a first capacitive arrangement (3) by means of a first measuring device (5), wherein the first change in voltage (ESA) is generated by means of a first series circuit (3, 4) including the first capacitive arrangement (3) and a first diode arrangement (4), wherein a first end of the first series circuit (3, 4) is electrically connected to the first conductor (EL) at a source-side side of the disconnecting switch (2), and which is configured such that, after disconnecting the first conductor (EL), a first current (EST) caused by the source-side part of the inductance (QTI) flows through the first series circuit (3, 4), which current (EST) leads to the first change in voltage (ESA) at the first capacitive arrangement (3);
measuring a second change in voltage (ZSA) at a second capacitive arrangement (6) by means of a second measuring device (8), wherein the second change in voltage (ZSA) is generated by means of a second series circuit (6, 7) including the second capacitive arrangement (6) and a second diode arrangement (7), wherein a first end of the second series circuit (6, 7) is electrically connected to the first conductor EL at a load-side side of the disconnecting switch (2), and which is configured such that, after disconnecting the first conductor (EL), a second current (ZST) caused by the load-side part of the inductance (LTI) flows through the second series circuit (6, 7), which current (ZST) leads to the second change in voltage (ZSA) at the second capacitive arrangement (6);
measuring, by means of a third measuring device (9), a third current (STR) on the first conductor (EL) before the first conductor (EL) is disconnected; and
evaluating the measured first change in voltage (ESA), the measured second change in voltage (ZSA), and the measured third current (STR) by means of an evaluation device (10) in order to determine the source-side part of the inductance (QTI) from the measured first change in voltage (ESA) and from the measured third current (STR), and in order to determine the load-side part of the inductance (LTI) from the measured second change in voltage (ZSA) and from the measured third current (STR).

## Revendications

1. Dispositif de mesure d'inductance de signal fort pour effectuer un processus de mesure d'une inductance (QTI, LTI) sur un aménagement de ligne d'alimentation d'énergie électrique (EL, ZL) fonctionnant avec une tension continue avec un premier conducteur (EL) et avec un deuxième conducteur (ZL), dans lequel le dispositif de mesure d'inductance de signal fort (1) est conçu pour être disposé entre un premier segment (EA) de l'aménagement de ligne d'alimentation d'énergie électrique (EL, ZL), qui est connecté à une source d'énergie électrique (EQ) et présente une partie du côté de la source de l'inductance (QTI), et un deuxième segment (ZA) de l'aménagement de ligne d'alimentation d'énergie électrique (EL, ZL), qui est connecté à une charge électrique (LA) et présente une partie du côté de la charge de l'inductance (LTI); le dispositif de mesure d'inductance de signal fort (1) comportant:

un disjoncteur (2) destiné à déconnecter électriquement le premier conducteur (EL) de l'aménagement de ligne d'alimentation d'énergie électrique (EL, ZL);
un premier circuit série (3, 4) comportant un premier aménagement capacitif (3) et un premier aménagement de diodes (4), où une première extrémité du premier circuit série (3, 4) au niveau de la face du côté de la source du disjoncteur (2) est connectée électriquement au premier conducteur (EL), et qui est conçue de sorte que, après la déconnexion du premier conducteur (EL), un premier courant (EST) provoqué par la partie du côté de la source de l'inductance (QTI) circule à travers le premier circuit série (3, 4), lequel conduit à une première variation de tension (ESA) au premier aménagement capacitif (3);
un premier dispositif de mesure (5) destiné à mesurer la première variation de tension (ESA);
un deuxième circuit série (6, 7) comportant un deuxième aménagement capacitif (6) et un deuxième aménagement de diodes (7), où une première extrémité du deuxième circuit série (6, 7) est connectée électriquement, au niveau de la face du côté de la charge du disjoncteur (2), au premier conducteur (EL) et qui est conçue de sorte que, après la déconnexion du premier conducteur (EL), un deuxième courant (ZST) provoqué par la partie du côté de la charge de l'inductance (LTI) circule à travers le deuxième circuit série (6, 7), lequel conduit à une deuxième variation de tension (ZSA) au deuxième aménagement capacitif (6);
un deuxième dispositif de mesure (8) destiné à mesurer la deuxième variation de tension (ZSA);
un troisième dispositif de mesure (9) destiné à mesurer un troisième courant (STR) au premier conducteur (EL) avant la déconnexion du premier conducteur (EL); et
un dispositif d'évaluation (10) destiné à évaluer la première variation de tension mesurée (ESA), la deuxième variation de tension mesurée (ZSA) et le troisième courant mesuré (STR) pour déterminer, à partir de la première variation de tension mesurée (ESA) et à partir du troisième courant mesuré (STR), la partie du côté de la source de l'inductance (QTI) et, à partir de la deuxième variation de tension mesurée (ZSA) et à partir du troisième courant mesuré (STR), la partie du côté de la charge de l'inductance (LTI).

2. Dispositif de mesure d'inductance de signal fort selon la revendication précédente, dans lequel le premier aménagement de diodes (3) est polarisé de sorte qu'il fonctionne, avant et après la déconnexion, dans la direction de passage.

3. Dispositif de mesure d'inductance de signal fort selon l'une des revendications précédentes, dans lequel le deuxième aménagement de diodes (7) est polarisé de sorte qu'il fonctionne, avant la déconnexion, dans la direction de blocage et, après la déconnexion, dans la direction de passage.

4. Dispositif de mesure d'inductance de signal fort selon l'une des revendications précédentes, dans lequel le disjoncteur (2) comporte un ou plusieurs commutateurs à semi-conducteur.

5. Dispositif de mesure d'inductance de signal fort selon l'une des revendications précédentes, dans lequel une deuxième extrémité du premier circuit série (3, 4) est connectée électriquement au deuxième conducteur (ZL) du système de ligne d'alimentation d'énergie électrique (EL, ZL).

6. Dispositif de mesure d'inductance de signal fort selon l'une des revendications 1 à 4, dans lequel une deuxième extrémité du premier circuit série (3, 4) est, au niveau de la face du côté de la charge du disjoncteur (2), connectée électriquement au premier conducteur (EL).

7. Dispositif de mesure d'inductance de signal fort selon l'une des revendications 1 à 4, dans lequel une deuxième extrémité du premier circuit série (3, 4) est connectée électriquement à une connexion électrique entre le deuxième aménagement capacitif (6) et le deuxième aménagement de diodes (7).

8. Dispositif de mesure d'inductance de signal fort selon l'une des revendications précédentes, dans lequel une deuxième extrémité du deuxième circuit série (6, 7) est connectée électriquement au deuxième conducteur (ZL) de l'aménagement de ligne d'alimentation d'énergie électrique (EL, ZL).

9. Dispositif de mesure d'inductance de signal fort selon l'une des revendications 1 à 5, dans lequel une deuxième extrémité du deuxième circuit série (6, 7) est, au niveau de la face du côté de la source du disjoncteur (2), connectée électriquement au premier conducteur (EL).

10. Dispositif de mesure d'inductance de signal fort selon l'une des revendications 1 à 5, dans lequel une deuxième extrémité du deuxième circuit série (6, 7) est connectée électriquement à une connexion électrique entre le premier aménagement capacitif (3) et le premier aménagement de diodes (4).

11. Dispositif de mesure d'inductance de signal fort selon l'une des revendications précédentes, dans lequel le dispositif de mesure d'inductance de signal fort (1) présente un circuit de décharge (11) qui est conçu pour décharger le premier aménagement capacitif (3) après l'achèvement du processus de mesure, de sorte que, après l'achèvement du processus de mesure, une tension présente au premier aménagement capacitif (3) corresponde à la tension de l'aménagement de ligne d'alimentation d'énergie électrique (EL, ZL).

12. Dispositif de mesure d'inductance de signal fort selon la revendication précédente, dans lequel le premier aménagement capacitif (3) comporte un circuit série composé de premiers condensateurs (14), dans lequel le circuit de décharge (11) est conçu pour décharger individuellement chacun des premiers condensateurs (14).

13. Dispositif de mesure d'inductance de signal fort selon l'une des revendications précédentes, dans lequel le dispositif de mesure d'inductance de signal fort (1) présente un circuit de charge (12) qui est conçu pour charger le deuxième aménagement capacitif (6) après l'achèvement du processus de mesure, de sorte que, après l'achèvement du processus de mesure, une tension présente au deuxième aménagement capacitif (6) corresponde à la tension de l'aménagement de ligne d'alimentation d'énergie électrique (EL, ZL).

14. Dispositif de mesure d'inductance de signal fort selon la revendication précédente, dans lequel le deuxième aménagement capacitif (6) comporte un circuit série composé de deuxièmes condensateurs (15), dans lequel le circuit de charge (12) est conçu pour charger individuellement chacun des deuxièmes condensateurs (15).

15. Dispositif de mesure d'inductance de signal fort selon l'une des revendications précédentes, dans lequel le dispositif de mesure d'inductance de signal fort (1) est conçu pour fermer le disjoncteur (2) après l'achèvement du processus de mesure.

16. Dispositif de mesure d'inductance de signal fort selon la revendication précédente, dans lequel le dispositif de mesure d'inductance de signal fort (1) présente un circuit de pré-charge (13) qui est conçu pour charger la charge (LA) avant la fermeture du disjoncteur (2), pour autant que la charge soit capacitive.

17. Procédé pour réaliser un processus de mesure pour mesurer une inductance (QTI, LTI) au niveau d'un aménagement de ligne d'alimentation d'énergie électrique (EL, ZL) fonctionnant avec une tension continue avec un premier conducteur (EL) et avec un deuxième conducteur (ZL) au moyen d'un dispositif de mesure d'inductance de signal fort (1), dans lequel le procédé comporte les étapes suivantes consistant à :

disposer le dispositif de mesure d'inductance de signal fort (1) entre un premier segment (EA) de l'aménagement de ligne d'alimentation d'énergie électrique (EL, ZL) qui est connecté à une source d'énergie électrique (EQ) et présente une partie du côté de la source de l'inductance (QTI), et un deuxième segment (ZA) de l'aménagement de ligne d'alimentation d'énergie électrique (EL, ZL) qui est connecté à une charge électrique (LA) et présente une partie du côté de la charge de l'inductance (LTI) ;
déconnecter électriquement le premier conducteur (EL) de l'aménagement de ligne d'alimentation de courant électrique (EL, ZL) au moyen d'un disjoncteur (2) ;
mesurer une première variation de tension (ESA) sur un premier aménagement capacitif (3) au moyen d'un premier dispositif de mesure (5), où la première variation de tension (ESA) est générée au moyen d'un premier circuit série (3, 4) comportant le premier aménagement capacitif (3) et un premier aménagement de diodes (4), où une première extrémité du premier circuit série (3, 4) est connectée électriquement, au niveau d'une face du côté de la source du disjoncteur (2), au premier conducteur (EL), et qui est conçue de sorte que, après la déconnexion du premier conducteur (EL), un premier courant (EST) provoqué par la partie du côté de la source de l'inductance (QTI) circule à travers le premier circuit série (3, 4), lequel conduit à la première variation de tension (ESA) au niveau du premier aménagement capacitif (3) ;
mesurer une deuxième variation de tension (ZSA) au niveau d'un deuxième aménagement capacitif (6) au moyen d'un deuxième dispositif de mesure (8), où la deuxième variation de tension (ZSA) est générée au moyen d'un deuxième circuit série (6, 7) comportant le deuxième aménagement capacitif (6) et un deuxième aménagement de diodes (7), où une première extrémité du deuxième circuit série (6, 7) au niveau d'une face du côté de la charge du disjoncteur (2) est connectée électriquement au premier conducteur (EL) et qui est conçue de sorte que, après la déconnexion du premier conducteur (EL), un deuxième courant (ZST) provoqué par la partie du côté de la charge de l'inductance (LTI) circule à travers le deuxième circuit série (6, 7), lequel conduit à la deuxième variation de tension (ZSA) au niveau du deuxième aménagement capacitif (6);

mesurer un troisième courant (STR) sur le premier conducteur (EL) avant la déconnexion du premier conducteur (EL) au moyen d'un troisième dispositif de mesure (9); et

évaluer la première variation de tension mesurée (ESA), la deuxième variation de tension mesurée (ZSA) et le troisième courant mesuré (STR) au moyen d'un dispositif d'évaluation (10) pour déterminer, à partir de la première variation de tension mesurée (ESA) et du troisième courant mesuré (STR), la partie du côté de la source de l'inductance (QTI) et pour déterminer, à partir la deuxième variation de tension mesurée (ZSA) et du troisième courant mesuré (STR), la partie du côté de la charge de l'inductance (LTI).

**Figur 1**

Messsystem

Last — $U_{DC}$ — ZL

Quelle — $U_{DC}$ — ZL

ZA — $L_2$ — LTI — $i_{L2}$ — EL

EA — $L_1$ — QTI — $i_{L1}$ — EL

$D_2$ — 7, $C_2$ — $u_{C2}$ — 6, 8

$D_1$ — 4, $C_1$ — $u_{C1}$ — 5, 3

S — 2, 10, 9, A, 1, LA, EQ

Figur 2

Figur 3

Figur 4

EP 4 141 455 B1

Figur 5

EP 4 141 455 B1

Figur 6

Figur 7

Figur 8

Messsystem

Quelle

Last

Figur 9

Figur 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4458196 A
- EP 3422029 A1
- US 20140019075 A1
- DE 3342378 A1
- US 20140028331 A1
- US 1058795652 B2
- WO 2020089462 A1

**In der Beschreibung aufgeführte Nicht-Patentliteratur**

- **A. KULKA ; T. UNDERLAND.** Grid Inductance Estimation by Reactive Power Perturbation. *Nordic Workshop on Power and Industrial Electronics,* 11. Juni 2008
- **A. TIMBUS ; R. TEODORESCU ; F. BLAABJERG.** Online Grid Impedance Measurement Suitable for Multiple PV Inverters Running in Parallel. *Twenty-First Annual IEEE Applied Power Electronics Conference and Exposition,* 2006